(19) Europäisches Patentamt
European Patent Office
Office européen des brevets

(11) **EP 4 345 065 A1**

(12) **EUROPEAN PATENT APPLICATION**

(43) Date of publication:
**03.04.2024 Bulletin 2024/14**

(21) Application number: **23193344.1**

(22) Date of filing: **25.08.2023**

(51) International Patent Classification (IPC):
**C01B 32/956** (2017.01)    **C01B 32/963** (2017.01)
**C01B 32/984** (2017.01)

(52) Cooperative Patent Classification (CPC):
**C01B 32/956; C01B 32/963; C01B 32/984**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.08.2022 KR 20220107882**

(71) Applicant: SENIC Inc.
**Seobuk-gu
Cheonan-si, Chungcheongnam-do 31040 (KR)**

(72) Inventors:
• **PARK, Jong Hwi
16278 Suwon-si, Gyeonggi-do (KR)**
• **KYUN, Myung Ok
16327 Suwon-si, Gyeonggi-do (KR)**

(74) Representative: **Isarpatent
Patent- und Rechtsanwälte
Barth Hassa Peckmann & Partner mbB
Friedrichstraße 31
80801 München (DE)**

(54) **SILICON CARBIDE POWDER**

(57)    A silicon carbide powder including carbon; and silicon, wherein a flow index under a major principal consolidation stress of 9 kPa is 0.005 to 0.3, and a flow index under a major principal consolidation stress of 0.3 kPa is 0.01 to 0.5.

FIG. 1

```
CRUSH SILICON CARBIDE RAW MATERIAL          S10
            ↓
REMOVE CARBON-BASED MATERIAL                S20
            ↓
PULVERIZE SILICON CARBIDE RAW MATERIAL      S30
            ↓
WET-ETCH SILICON CARBIDE RAW MATERIAL       S40
            ↓
DRY-ETCH SILICON CARBIDE RAW MATERIAL       S50
            ↓
CLEAN SILICON CARBIDE RAW MATERIAL          S60
            ↓
CLASSIFY SILICON CARBIDE RAW MATERIAL       S70
```

EP 4 345 065 A1

**Description**

Technical Field

One embodiment relates to a silicon carbide powder and a method of manufacturing a silicon carbide ingot.

Background Art

Silicon carbide (SiC) has excellent heat resistance and mechanical strength, is highly resistant to radiation, and may be used even to produce large-diameter substrates. In addition, silicon carbide has excellent physical strength and chemical resistance, a large energy band gap, and a large electron saturation drift rate and pressure resistance. Accordingly, silicon carbide is widely used in abrasives, bearings, fireproof plates, and the like as well as semiconductor devices that require high power, high efficiency, high voltage resistance, and high capacity.

Silicon carbide is manufactured through various methods such as heat treatment or electrification of carbon raw materials such as silicon carbide waste. Examples of conventional methods include the Acheson method, a reactive sintering method, an atmospheric pressure sintering method, and a chemical vapor deposition (CVD) method. In these methods have a problem in that carbon raw materials remain. These residues act as impurities and may deteriorate the thermal, electrical, and mechanical properties of silicon carbide.

For example, Japanese Patent Publication No. 2002-326876 discloses a method of reacting a silicon carbide precursor, which has undergone a heat treatment process, at a high temperature under an inert gas condition such as argon (Ar) to polymerize or cross-link a silicon source and a carbon source. However, this process has problems in that the manufacturing cost is high and the size of the powder is not uniform due to heat treatment at a high temperature of 1,800°C to 2,100°C under a vacuum or inert gas condition.

Moreover, wafers used in the solar cell and semiconductor industries are manufactured by growing from silicon ingots in a crucible made of graphite or the like and, during this manufacturing process, a significant amount of silicon carbide waste, adsorbed on the inner wall of the crucible, as well as a waste slurry containing silicon carbide is generated. However, landfill disposal of such waste has caused environmental problems which can result in high disposal costs.

SUMMARY

In one embodiment of the present disclosure, there is provided a silicon carbide powder capable of improving the growth rate of a silicon carbide ingot and lowering the defect of a silicon carbide wafer and a method of manufacturing a silicon carbide wafer using the silicon carbide powder.

In accordance with one aspect of the present disclosure, there is provided a silicon carbide powder, including: carbon; and silicon, wherein a flow index under a major principal consolidation stress of 9 kPa may range from 0.005 to 0.3, and a flow index under a major principal consolidation stress of 0.3 kPa may range from 0.01 to 0.5.

In the silicon carbide powder according to one embodiment, the flow index under a major principal consolidation stress of 9 kPa may range from 0.01 to 0.1, and the flow index under a major principal consolidation stress of 0.3 kPa may range from 0.02 to 0.3.

In the silicon carbide powder according to another embodiment, an average particle diameter of the silicon carbide powder may range from 100 $\mu$m to 5000 $\mu$m.

In the silicon carbide powder according to another embodiment, a ratio of the flow index under a major principal consolidation stress of 0.3 kP to the flow index under a major principal consolidation stress of 9 kPa may range from 1:1 to 4:1.

In the silicon carbide powder according to another embodiment, a repose angle of the silicon carbide powder may range from 30° to 45°.

In the silicon carbide powder according to another embodiment, a tap density of the silicon carbide powder may range from 1000 kg/m$^3$ to 2000 kg/m$^3$.

In the silicon carbide powder according to another embodiment, an unconfined failure strength of the silicon carbide powder under a major principal consolidation stress of 9 kPa may range from 0.2 kPa to 1 kPa.

In the silicon carbide powder according to another embodiment, the flow index under a major principal consolidation stress of 9 kPa relative to an average particle diameter may be less than 0.0006/$\mu$m.

In the silicon carbide powder according to another embodiment, the flow index under a major principal consolidation stress of 0.3 kPa relative to an average particle diameter may be less than 0.0007/$\mu$m.

In accordance with another aspect of the present disclosure, there is provided a method of manufacturing a silicon carbide wafer, the method including: preparing a silicon carbide powder including carbon and silicon, wherein a flow index under a major principal consolidation stress of 9 kPa ranges from 0.005 to 0.3, and a flow index under a major principal consolidation stress of 0.3 kPa ranges from 0.01 to 0.5; growing a silicon carbide ingot using the silicon carbide powder; and processing the silicon carbide ingot.

In one embodiment, in the growing of the silicon carbide ingot, the silicon carbide powder may be filled in a crucible, and the silicon carbide powder filled in the crucible may have a bulk density ranging from 1400 kg/m$^3$ to 1700 kg/m$^3$.

In accordance with yet another aspect of the present disclosure, there is provided a method of manufacturing a silicon carbide powder, the method including: providing a raw material including silicon carbide; and powdering the raw material, wherein a flow index of the powdered raw material under a major principal consolidation stress of 9 kPa ranges from 0.005 to 0.3, and a flow index of the powdered raw material under a major principal consolidation stress of 0.3 kPa ranges from 0.01 to 0.5.

Description of Drawings

FIG. 1 is a flowchart illustrating a manufacturing process of a silicon carbide powder according to one embodiment.
FIG. 2 is a flowchart illustrating a manufacturing process of a silicon carbide powder according to another embodiment.
FIG. 3 is a flowchart illustrating a manufacturing process of a silicon carbide powder according to another embodiment.
FIG. 4 is a flowchart illustrating a manufacturing process of a silicon carbide powder according to another embodiment.
FIG. 5 is a flowchart illustrating a manufacturing process of a silicon carbide powder according to another embodiment.
FIG. 6 is a flowchart illustrating a manufacturing process of a silicon carbide powder according to another embodiment.
FIG. 7 is a sectional view illustrating a process of growing a silicon carbide ingot.

Detailed DescriptionHereinafter, the invention will be described in detail through embodiments. The present disclosure is not limited to the embodiments disclosed below and may be modified in various forms within the scope of the invention.

In the present specification, unless otherwise specified when a part "comprises" a certain component, it means that other components may be further comprised, rather than excluding other components,.

It should be understood that all numbers and expressions indicating the amounts of components, reaction conditions, etc. described in this specification are modified by the term "about" in all cases unless otherwise specified. The term "about" refers to variations in the magnitude of the quantity described of +/- 2%.

It should be understood that, for the ranges described, the present disclosure includes all intermediate values and sub-ranges within the specified range described.

In one embodiment, there is provided a silicon carbide powder which has a flow index in an appropriate range under a major principal consolidation stress of 9 kPa. In addition, the silicon carbide powder may have a flow index in an appropriate range under a major principal consolidation stress of 0.3 kPa. In addition, the silicon carbide powder according to one embodiment can have a repose angle in an appropriate range. In addition, the silicon carbide powder according to one embodiment can have a tap density in an appropriate range.

Accordingly, the silicon carbide powder of the present disclosuremay be filled in a crucible to manufacture a silicon carbide ingot and a silicon carbide wafer. In addition, since the silicon carbide powder has a flow index, repose angle and tap density in appropriate ranges as described above, it can have an appropriate bulk density when filled in the crucible. In addition, since the silicon carbide powder has a flow index, repose angle and tap density in appropriate ranges as described above, it can have appropriate particle shape and appropriate surface characteristics when filled in the crucible, thereby realizing appropriate porosity and appropriate thermal conductivity.

Accordingly, the silicon carbide powder according to one embodiment has improved thermal conductivity in a horizontal direction and a porosity in an appropriate range when filled in the crucible. Accordingly, when the silicon carbide powder is filled in the crucible and heated for the growth of the silicon carbide ingot, it can have a uniform temperature gradient in the horizontal direction and can transfer a silicon carbide gas sublimated into a pore to a silicon carbide seed tablet.

Accordingly, the silicon carbide powder of the present disclosure can deliver the sublimated silicon carbide gas upward at an improved and uniform rate. Accordingly, the silicon carbide powder can improve the growth rate of the silicon carbide ingot. In addition, since the silicon carbide gas sublimes at a uniform rate throughout, defects of the silicon carbide ingot and the silicon carbide wafer may be reduced.

The growth process of the silicon carbide ingot may depend on the particle shape and surface characteristics of the silicon carbide powder according to one embodiment. Here, the particle shape and particle surface properties of the silicon carbide powder may be appropriately controlled by a crushing process, a pulverization process, and an etching process. The particle shape and particle surface characteristics of the silicon carbide powder according to one embodiment may be determined by analyzing the flow index, the repose angle and the tap density. When the silicon carbide powder has a flow index, repose angle and tap density within appropriate ranges, it can have a particle shape and particle surface that positively affects the growth of the silicon carbide ingot.

First, a method of manufacturing a silicon carbide powder according to one embodiment includes an operation of preparing a silicon carbide raw material.

The silicon carbide raw material includes silicon carbide. The silicon carbide raw material may include α-phase silicon carbide and/or β-phase silicon carbide. In addition, the silicon carbide raw material may include a silicon carbide monocrystal and/or a silicon carbide polycrystal.

In addition, the silicon carbide raw material may further include unwanted impurities in addition to silicon carbide.

The silicon carbide raw material may further include a carbon-based material such as graphite as an impurity. The carbon-based material may be derived from a graphite crucible and the like. The carbon-based material may be included in the silicon carbide raw material in a content ranging from about 5 % by weight to about 50 % by weight. The carbon-based material may be included in a content of about 50 % by weight or less in the silicon carbide raw material. The carbon-based material may be included in a content of about 45 % by weight or less in the silicon carbide raw material. The carbon-based material may be included in a content of about 40 % by weight or less in the silicon carbide raw material. The carbon-based material may be included in a content ranging from about 1 % by weight to about 50 % by weight in the silicon carbide raw material. The carbon-based material may be included in a content ranging from about 5 % by weight to about 45 % by weight in the silicon carbide raw material. The carbon-based material may be included in a content ranging from about 10 % by weight to about 40 % by weight in the silicon carbide raw material. The carbon-based material may be included in a content ranging from about 10 % by weight to about 35 % by weight in the silicon carbide raw material. The carbon-based material may be included in a content ranging from about 10 % by weight to about 30 % by weight in the silicon carbide raw material. The carbon-based material may be included in a content ranging from about 10 % by weight to about 20 % by weight in the silicon carbide raw material.

The silicon carbide raw material may further include free silicon as the impurity. The free silicon may be derived from a silicon substrate and/or a silicon component, etc. The silicon component may be a component applied to a semiconductor equipment such as a focus ring. The free silicon may be included in a content ranging from about 0.01 % by weight to about 10 % by weight in the silicon carbide raw material.

The silicon carbide raw material may further include a metallic impurity. The metallic impurity may be at least one or more selected from the group consisting of lithium, boron, sodium, aluminum, phosphorus, potassium, calcium, titanium, vanadium, chromium, manganese, iron, nickel, copper, zinc, strontium, zirconium, molybdenum, tin, barium, tungsten, and lead.

The content of the metallic impurity may range from about 0.1 ppm to 13 ppm. The content of the metallic impurity may range from about 0.3 ppm to 12 ppm. The content of the metallic impurity may range from about 0.5 ppm to 8 ppm. The content of the metallic impurity may range from about 0.8 ppm to 10 ppm. The content of the metallic impurity may range from about 1 ppm to 6 ppm. The content of the metallic impurity may range from about 0.1 ppm to 5 ppm. The content of the metallic impurity may range from about 0.5 ppm to 3 ppm. The content of the metallic impurity may range from about 0.5 ppm to 2 ppm. The silicon carbide raw material may further include a metallic impurity.

The silicon carbide raw material may further include a non-metallic impurity. The non-metallic impurity may be one or more selected from the group consisting of fluorine, nitrogen, chlorine, and phosphorus.

The content of the non-metallic impurity may range from about 0.01 ppm to 13 ppm. The content of the non-metallic impurity may range from about 0.03 ppm to 12 ppm. The content of the non-metallic impurity may range from about 0.05 ppm to 8 ppm. The content of the non-metallic impurity may range from about 0.08 ppm to 10 ppm. The content of the non-metallic impurity may range from about 0.1 ppm to 6 ppm. The content of the non-metallic impurity may range from about 0.1 ppm to 5 ppm. The content of the non-metallic impurity may range from about 0.5 ppm to 3 ppm. The content of the non-metallic impurity may range from about 0.5 ppm to 2 ppm.

The silicon carbide raw material may have a lump shape. The silicon carbide raw material may have a plate shape.

The silicon carbide raw material may include about 30 % by weight or more of particles having diameter of about 1 mm or more. The silicon carbide raw material may include about 50 % by weight or more of particles having diameter of about 1 mm or more. The silicon carbide raw material may include about 70 % by weight or more of particles having diameter of about 1 mm or more.

The silicon carbide raw material may include about 30 % by weight or more of particles having diameter of about 10 mm or more. The silicon carbide raw material may include about 50 % by weight or more of particles having diameter of about 10 mm or more. The silicon carbide raw material may include about 70 % by weight or more of particles having diameter of about 10 mm or more.

Here, a sphere having the same volume as the volume of the particle is assumed, and the diameter of the sphere is defined as the particle diameter.

In addition, the silicon carbide raw material may be derived from a substrate including silicon carbide. The silicon carbide raw material may be derived from a wafer entirely including silicon carbide. The silicon carbide raw material may be derived from a silicon carbide layer, deposited on a substrate, such as silicon.

In addition, the silicon carbide raw material may be derived from a silicon carbide monocrystal ingot. This silicon carbide monocrystal ingot may have been discarded due to defects occurring during a prior manufacturing process. Alternatively, the silicon carbide raw material may be derived from a silicon carbide polycrystal.

The silicon carbide raw material may be derived from a silicon carbide sintered body. The silicon carbide sintered body may be formed by sintering a silicon carbide powder. The silicon carbide sintered body may be a component included in semiconductor manufacturing equipment.

The silicon carbide raw material may be derived from a graphite component including a silicon carbide layer. The graphite component may include a crucible for forming a silicon carbide ingot, etc.

The silicon carbide raw material may be derived from a component of a semiconductor equipment including a silicon carbide layer. The silicon carbide layer may be formed by depositing silicon carbide on the surface on a silicon component, etc. by a chemical vapor deposition (CVD) process.

The method of manufacturing a silicon carbide powder according to anoter embodiment may include an operation of cutting the silicon carbide raw material.

When the silicon carbide raw material is too large, the silicon carbide raw material may be cut by a wire saw or bar cutting which includes diamond abrasive grains, etc. The silicon carbide raw material may be cut to a length of 150 mm.

The method of manufacturing a silicon carbide powder according to an embodiment may include an operation of crushing a silicon carbide raw material.

The operation of crushing a silicon carbide raw material may be a process of breaking the silicon carbide raw material into particles having an average particle diameter of about 100 mm or less. By the crushing process, the silicon carbide raw material may be split into particles having an average particle diameter of about 80 mm or less. By the crushing process, the silicon carbide raw material may be split into particles having an average particle diameter of about 60 mm or less. By the crushing process, the silicon carbide raw material may be split into particles having an average particle diameter of about 50 mm or less. By the crushing process, the silicon carbide raw material may be split into particles having an average particle diameter ranging from about 0.1 mm to about 50 mm. By the crushing process, the silicon carbide raw material may be split into particles having an average particle diameter ranging from about 1 mm to about 40 mm.

In the crushing process, a jaw crusher, a cone crusher, or a gyratory crusher may be used.

The jaw crusher includes a pair of compression plates, and the silicon carbide raw material is inserted between the compression plates. The silicon carbide raw material is crushed by the pressure applied through the compression plates, and the crushed silicon carbide raw material may be discharged downward by magnetic gravity.

Each of the compression plates may include at least one or more of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be coated with tungsten carbide.

The gyratory crusher includes a crushing head and a crushing bowl accommodating the crushing head. The crushing head has a truncated cone shape, and the crushing head is mounted on a shaft. An upper end of the crushing head is fixed to a flexible bearing, and a lower end of the crushing head is driven eccentrically to draw a circle. The crushing action is made around the entire cone, and the maximum movement is made at the bottom. Accordingly, since the crushing of the gyratory crusher continues to operate, the gyratory crusher has less stress fluctuation and lower power consumption than the jaw crusher.

Like the jaw crusher, the crushing head and the crushing bowl which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the crushing head and the crushing bowl which are in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the crushing head and the crushing bowl in direct contact with the silicon carbide raw material may be coated with tungsten carbide.

The cone crusher is a device for crushing the silicon carbide raw material by both an impact force and compression force. The cone crusher has a similar structure and crushing motion to the gyratory crusher. However, the cone crusher may have shorter cones. The cone crusher includes an umbrella-shaped cone mantle head mounted on a vertical central axis. By the eccentric motion of the cone mantle head, the silicon carbide raw material is compressed into a cone cave bowl, and as it goes down, the silicon carbide raw material is crushed.

Like the jaw crusher, the cone mantle head and the cone cave bowl whish are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the cone mantle head and the cone cave bowl in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portion of the cone mantle head and the cone cave bowl in direct contact with the silicon carbide raw material may be coated with tungsten carbide.

The method of manufacturing a silicon carbide powder according to another embodiment may include an operation of pulverizing a silicon carbide raw material.

The operation of pulverizing a silicon carbide raw material may include a process of breaking the silicon carbide raw material into particles having a diameter of about 30 mm or less. By the pulverization process, the silicon carbide raw material may be split into particles having an average particle diameter of about 20 mm or less. By the pulverization process, the silicon carbide raw material may be split into particles having an average particle diameter of about 15 mm or less. By the pulverization process, the silicon carbide raw material may be split into particles having an average particle diameter of about 10 mm or less. By the pulverization process, the silicon carbide raw material may be split into particles having an average particle diameter ranging from 0.1 mm to about 10 mm. By the pulverization process, the silicon carbide raw material may be split into particles having an average particle diameter ranging from about 0.1 mm to about 8 mm. By the pulverization process, the silicon carbide raw material may be split into particles having an average particle diameter ranging from about 0.01 mm to about 6 mm.

In the pulverization process, a ball mill, a hammer crusher, a jet mill, or the like may be used.

The ball mill may include a metal cylinder and a ball. The ball and the silicon carbide raw material are placed in the metal cylinder. When the metal cylinder rotates, the ball and the silicon carbide raw material may be rotated by the friction between the ball and the silicon carbide raw material and the centrifugal force within the metal cylinder. At this time, the ball and the silicon carbide raw material rise to a certain height in the cylinder, and then fall, and the silicon carbide raw material is pulverized and polished. Depending on the rotational speed of the cylinder, the inner diameter of the cylinder, the size of the ball, the material of the ball, and the time of the pulverization process, the silicon carbide raw material may be split into particles having a small diameter.

The metal cylinder and the ball which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portion of the metal cylinder and the ball in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the metal cylinder and the ball in direct contact with the silicon carbide raw material may be coated with tungsten carbide.

The hammer crusher includes a chamber and multiple hammers. The hammers are mounted on a rotating body placed within the chamber. The hammers rotate within the chamber, and the hammers impact on the silicon carbide raw material. Accordingly, the silicon carbide raw material may be split into particles having a small diameter.

The chamber and the hammers which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be coated with tungsten carbide.

The jet mill includes a chamber and a nozzle. The jet mill pulverizes the silicon carbide raw material by mutually colliding the silicon carbide raw materials with each other under the energy of injection from the nozzle by the pressure of a fluid. The silicon carbide raw material is pulverized in the chamber until the particle size thereof reaches a desired size. In addition, the particles subjected to the pulverization process are collected through a classification chamber from the jet mill chamber. Since the jet mill pulverizes the silicon carbide raw material by mutual collision of the silicon carbide raw material by the pressure of fluid, the contamination of the silicon carbide raw material by direct contact with other non-silicon carbide devices may be minimized.

The chamber which is a part in direct contact with the silicon carbide raw material may include at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be coated with tungsten carbide.

The average particle diameter (D50) of the crushed particles may range from about 1 mm to about 15 mm, and the average particle diameter (D50) of the crushed particles may range from about 100 $\mu$m to about 3 mm. The average particle diameter (D50) of the crushed particles may range from about 3 mm to about 10 mm, and the average particle diameter (D50) of the crushed particles may be about 100 $\mu$m to about 1 mm. The average particle diameter (D50) of the crushed particles may range from about 1 mm to about 3 mm, and the average particle diameter (D50) of the crushed particles may range from about 300 μm to about 0.8 mm. The average particle diameter (D50) of the crushed particles may range from about 7 mm to about 13 mm, and the average particle diameter (D50) of the crushed particles may range from about 500 μm to about 1.5 mm. The average particle diameter (D50) of the crushed particles may range from about 1 mm to about 3 mm, and the average particle diameter (D50) of the crushed particles may range from about 100 μm to about 800 μm. The average particle diameter (D50) of the crushed particles may range from about 6 mm to about 10 mm, and the average particle diameter (D50) of the crushed particles may range from about 1 mm to about 3 mm. The average particle diameter (D50) of the crushed particles may range from about 4 mm to about 8 mm, and the average particle diameter (D50) of the crushed particles may range from about 800 μm to about 2 mm. Since the crushing process and the pulverizing process are carried out to have an average particle diameter (D50) within the above range, the silicon carbide powder according to an embodiment may be manufactured to have a desired particle diameter and shape.

The pulverization process may be a ball mill process. In the ball mill process, the diameter of a ball may range from about 5 mm to about 50 mm. The diameter of the ball may range from about 10 mm to about 40 mm.

In the ball mill process, the rotation speed of a cylinder may range from about 10 rpm to about 40 rpm. In the ball mill process, the rotation speed of the cylinder may range from about 15 rpm to about 35 rpm.

In the ball mill process, a steel ball may be used. The ball mill process may be carried out for about 10 minutes to about 30 minutes.

**[0071]**    , A ball diameter and cylinder rotation speed in the ball mill process and the running time of the ball mill process may be controlled within the above described ranges to control the particle size and shape of the silicon carbide powder according to embodiments.

The method of manufacturing a silicon carbide powder according to one embodiment may further include an operation of removing iron by magnetic force.

The operation of removing an iron component may be an operation of removing iron adsorbed to the silicon carbide raw material in the crushing and pulverizing operations.

In the operation of removing an iron component, a rotary metal detector may be used to remove the iron.

A rotation speed of the rotary metal detector may range from about 100 rpm to about 800 rpm, and an output power of an electromagnet included in the rotary metal detector may be about 0.5 kW to about 3 kW. In addition, a rotation speed of the rotary metal detector may be about 800 rpm to about 1700 rpm, and an output power of an electromagnet included in the rotary metal detector may be about 3 kW to about 5 kW.

The content of iron contained in the silicon carbide raw material from which iron has been removed may be about 1 ppm or less. The content of iron contained in the silicon carbide raw material from which iron has been removed about 0.5 ppm or less. The content of iron contained in the silicon carbide raw material from which iron has been removed about 0.3 ppm or less. The content of iron contained in the silicon carbide raw material from which iron has been removed about 0.1 ppm or less.

The method of manufacturing a silicon carbide powder according to an embodiment includes an operation of removing the carbon-based material.

The operation of removing the carbon-based material may include an operation of physically removing the carbon-based material.

The operation of physically removing the carbon-based material may include a steel cut wire shot process. A wire used for the steel cut wire shot may be made of carbon steel, stainless steel, aluminum, zinc, nickel, copper, or an alloy thereof, but is not limited thereto. In addition, the diameter of the wire may range from about 0.2 mm to about 0.8 mm. The diameter of the wire may range from about 0.4 mm to about 0.6 mm.

A rotation speed of the wire may range from about 1000 rpm to about 5000 rpm.

In addition, the operation of physically removing the carbon-based material may include a blasting process such as sand blasting or short blasting. The blasting process may be a process of spraying fine particles on the carbon-based material such as graphite to remove the carbon-based material. That is, since the carbon-based material has a lower hardness than the silicon carbide, it may be removed by fine particles sprayed with an appropriate pressure.

In addition, the operation of physically removing the carbon-based material may include a separation process using density difference, and using centrifugation. The crushed and/or pulverized silicon carbide raw material may be separated by a density difference between the carbon-based material and the silicon carbide. That is, since the density of silicon carbide is larger than the density of graphite, the carbon-based material may be removed by density gradient centrifugation, etc.

After the operation of physically removing the carbon-based material, the content of the carbon-based material included in the raw material may be about 5 % by weight or less. After the operation of removing the carbon-based material, the content of the carbon-based material included in the raw material may be about 3 % by weight or less. After the operation of removing the carbon-based material, the content of the carbon-based material included in the raw material may be about 1 % by weight or less.

In addition, the operation of removing the carbon-based material may include an operation of chemically removing the carbon-based material.

The operation of chemically removing the carbon-based material may include an operation of oxidizing the carbon-based material.

After the carbon-based material contained in the raw material is sufficiently removed, the raw material is heat-treated in an oxygen or atmospheric atmosphere. At this time, the oxidative heat treatment temperature may be about 1000 °C to about 1200 °C. The heat treatment time may be about 12 hours to about 48 hours.

Since the raw material is heat-treated in the above time and temperature ranges, the carbon-based material contained in the raw material may be effectively removed. In addition, since the raw material is heat-treated in the above time and temperature ranges, the generation of by-products such as silicon oxide in the raw material may be minimized.

The method of manufacturing a silicon carbide powder according to an embodiment includes an operation of classifying the silicon carbide raw material. In the classifying operation, the silicon carbide raw material granulated through the crushing process and the pulverizing process may be classified.

The granulated silicon carbide raw material may be classified by a mesh of a desired size.

The classifying operation may be performed using a twist screen that is a vibrating classifying device.

The twist screen may include a silicon tapping ball having a diameter range from 10 mm to 80 mm, 15 mm to 70 mm, or 20 mm to 60 mm. Using the twist screen, the classifying operation may be performed for about 10 minutes to about 100 minutes under a vibration condition of about 1000 times/minute to about 3000 times/minute.

The granulated silicon carbide raw material may be fed into the twist screen at a constant speed.

The particle diameter (D50) of the granulated silicon carbide raw material may range from about 10 $\mu$m to about 10000 $\mu$m. The particle diameter (D50) of the granulated silicon carbide raw material may range from about 100 $\mu$m to about 6000 $\mu$m. The particle diameter (D50) of the granulated silicon carbide raw material may range from about 60 $\mu$m to about 5000 $\mu$m. The particle diameter (D50) of the granulated silicon carbide raw material may range from about 100 $\mu$m to about 4000 $\mu$m. The particle diameter (D50) of the granulated silicon carbide raw material may range from about 150 $\mu$m to about 400 $\mu$m. The particle diameter (D50) of the granulated silicon carbide raw material may range from about 300 $\mu$m to about 800 $\mu$m. The particle diameter (D50) of the granulated silicon carbide raw material may range from about 500 $\mu$m to about 1000 $\mu$m. The particle diameter (D50) of the granulated silicon carbide raw material may range from about 700 $\mu$m to about 2000 $\mu$m. The particle diameter (D50) of the granulated silicon carbide raw material may range from about 1000 $\mu$m to about 3000 $\mu$m.

The method of manufacturing a silicon carbide powder according to one embodiment may include an operation of wet etching the silicon carbide raw material.

The wet etching operation is carried out by an etchant. The silicon carbide raw material that has undergone the crushing and pulverizing processes may be subjected to the wet etching operation.

The etchant may include water and acid. The acid may be at least one selected from the group consisting of hydrofluoric acid, nitric acid, hydrochloric acid, and sulfuric acid.

The etchant may include deionized water, hydrofluoric acid, and nitric acid.

The hydrofluoric acid may be included in a content ranging from about 10 parts by weight to about 50 parts by weight based on 100 parts by weight of the deionized water in the etchant. The hydrofluoric acid may be included in a content ranging from about 15 parts by weight to about 45 parts by weight based on 100 parts by weight of the deionized water in the etchant. The hydrofluoric acid may be included in a content ranging from about 20 parts by weight to about 40 parts by weight based on 100 parts by weight of the deionized water in the etchant.

The nitric acid may be included in a content ranging from about 10 parts by weight to about 50 parts by weight based on 100 parts by weight of the deionized water in the etchant. The nitric acid may be included in a content ranging from about 15 parts by weight to about 45 parts by weight based on 100 parts by weight of the deionized water in the etchant. The nitric acid may be included in a content ranging from about 20 parts by weight to about 40 parts by weight based on 100 parts by weight of the deionized water in the etchant.

The etchant may be filled in an etch vessel. Here, the etchant may be filled in an amount ranging from about 10 vol% to about 20 vol% based on the total volume of the etch vessel in the etch vessel. The etchant may be filled in an amount ranging from about 12 vol% to about 18 vol% based on the total volume of the etch vessel in the etch vessel. In addition, the silicon carbide raw material may be filled in an amount ranging from about 10 vol% to about 30 vol% based on the total volume of the etch vessel in the etch vessel. The silicon carbide raw material may be filled in an amount ranging from about 15 vol% to about 25 vol% based on the total volume of the etch vessel in the etch vessel.

The silicon carbide raw material may be wet-etched by the etchant. That is, the surface of the silicon carbide raw material may be etched by the etchant, and impurities remaining on the surface of the silicon carbide raw material may be removed by the etchant.

The wet etching operation may be carried out according to the following processes.

First, the etch vessel and the silicon carbide raw material may be dried. The etch vessel and the silicon carbide raw material may be dried with hot air at about 50 °C to about 150 °C for about 10 minutes to about 1 hour.

Next, the silicon carbide raw material is placed in the etch vessel.

Next, the etchant is fed into the etch vessel in which the silicon carbide raw material has been placed.

A process of feeding the etchant may be as follows.

First, deionized water is fed into the etch vessel in which the silicon carbide raw material has been placed.

Next, hydrofluoric acid is fed into the etch vessel into which the deionized water has been fed.

Next, nitric acid is fed into the etch vessel into which the hydrofluoric acid has been fed.

Next, the etch vessel into which the etchant has been fed is sealed by a lid, the silicon carbide raw material and etchant contained in the etch vessel are stirred at a speed ranging from about 50 rpm to about 500 rpm. The stirring time may range from about 30 minutes to about 2 hours.

Next, the etchant is drained, and the silicon carbide raw material subjected to the wet etching process is precipitated several times in deionized water and neutralized. At this time, after precipitation, the neutralization process of the silicon carbide raw material that has undergone the wet etching process may be completed based on the content and/or pH of hydrofluoric acid contained in the drained wastewater. When the pH of the wastewater is 6.8 to 7.2, the neutralization process may be finished.

The method of manufacturing a silicon carbide powder according to an embodiment may include an operation of dry etching the silicon carbide raw material.

The dry etching process may be performed by spraying an etching gas onto the silicon carbide raw material.

The etching gas may include a chlorine gas. The etching gas may further include an inert gas such as argon as a carrier gas.

The dry etching process may be carried out as follows.

First, a dry etching furnace is prepared. The dry etching furnace may be made of graphite and may be heated to a temperature of about 2000°C or more. The dry etching furnace is sealed against the outside, and the inside of the dry etching furnace may be depressurized up to about 5 Torr or less.

The silicon carbide raw material is placed in the dry etching furnace.

Next, the dry etching furnace is heated up to a temperature ranging from about 1800 °C to about 2200 °C.

Next, the inside of the dry etching furnace is depressurized to a pressure ranging from about 1 Torr to about 30 Torr. The inside of the dry etching furnace is depressurized to a pressure ranging from about 1 Torr to about 10 Torr. The inside of the dry etching furnace is depressurized to a pressure ranging from about 1 Torr to about 8 Torr.

Next, the etching gas is fed into the dry etching furnace. The etching gas may be convected in the dry etching furnace by a temperature difference between the lower portion and the upper portion of the dry etching furnace. That is, the temperature of the lower portion of the dry etching furnace may be about 50 °C to about 100 °C higher than the temperature of the upper portion of the dry etching furnace, so that the etching gas at the lower portion of the dry etching furnace moves to the upper portion of the dry etching furnace, thereby dry etching the surface of the silicon carbide raw material. The residence time of the etching gas in the dry etching furnace may range from about 24 hours to about 96 hours.

Next, the etching gas may be removed by a wet scrubber, and the pressure of the inside of the dry etching furnace may be increased to about 600 Torr to about 780 Torr.

The dry etching process may additionally include a heat treatment process and an oxide film removal process.

The dry-etched silicon carbide particles may be heat-treated at a temperature ranging from about 700 °C to about 1300 °C in an atmosphere containing oxygen in the dry etching furnace. The dry-etched silicon carbide particles may be heat-treated at a temperature ranging from about 800 °C to about 1200 °C in an atmosphere containing oxygen in the dry etching furnace. The dry-etched silicon carbide particles may be heat-treated at a temperature ranging from about 900 °C to about 1100 °C in an atmosphere containing oxygen in the dry etching furnace. The heat treatment time may range from about 10 minutes to about 2 hours. The heat treatment time may range from about 20 minutes to about 1 hour.

By the heat treatment, chlorine remaining on the surface of the dry-etched silicon carbide particles may be removed.

The oxide film removal process may include a wet etching process.

The heat-treated silicon carbide raw material is fed into an etch vessel, and deionized water and hydrofluoric acid are additionally fed into the etch vessel.

Next, the silicon carbide raw material and etchant in the etch vessel may be stirred, and an oxide film on the surface of the silicon carbide raw material may be removed.

The silicon carbide raw material from which the oxide film has been removed is neutralized by deionized water.

The method of manufacturing a silicon carbide powder according to an embodiment may include an operation of cleaning the silicon carbide raw material.

The cleaning process may be carried out using a cleaning solution including at least one selected from the group consisting of hydrofluoric acid, distilled water, and ultrapure water.

The cleaning process may include a first cleaning operation, a first hydrofluoric acid treatment operation, a second cleaning operation, a second hydrofluoric acid treatment operation, and a third cleaning operation.

**EP 4 345 065 A1**

The first cleaning operation may be performed for 1 minute to 300 minutes using distilled water, ultrapure water, or pure water. For example, the first cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the first hydrofluoric acid treatment operation is an operation of cleaning the silicon carbide raw material using a cleaning solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes or about 20 minutes to about 40 minutes in the cleaning solution. Next, the silicon carbide raw material may be precipitated in the cleaning solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution.

The second cleaning operation may be performed for 1 minute to 300 minutes using distilled water, ultrapure water, or pure water. For example, the second cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the second hydrofluoric acid treatment operation is an operation of cleaning the silicon carbide raw material using a cleaning solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution. Next, the silicon carbide raw material may be precipitated in the cleaning solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the cleaning solution.

The third cleaning operation may be performed for 1 minute to 300 minutes using distilled water, ultrapure water, or pure water. For example, the third cleaning operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

By the graphite removal process, the iron component removal process, the wet etching process, the dry etching process, and the cleaning process, the silicon carbide powder according to an embodiment may have a very high purity.

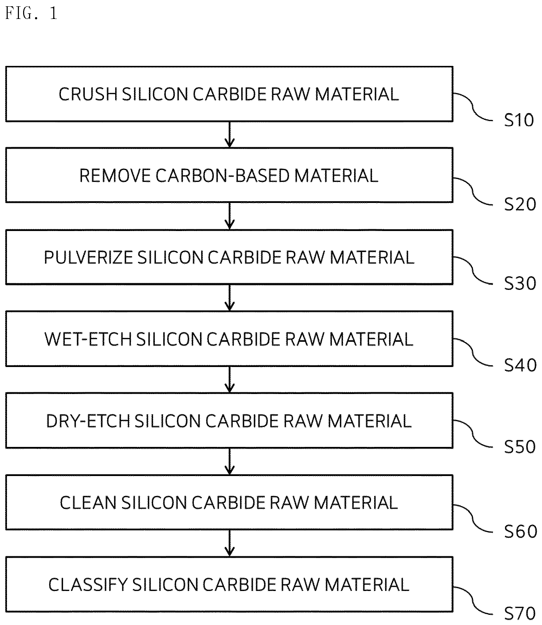

Referring to FIG. 1, a silicon carbide powder according to one embodiment may be manufactured by the following process.

First, the silicon carbide raw material is crushed in the crushing process (S10).

Next, by the carbon-based material removal process, a carbon-based material such as graphite included in the silicon carbide raw material is removed (S20).

Next, the silicon carbide raw material from which a carbon-based material has been removed is pulverized by the pulverization process (S30).

Next, the pulverized silicon carbide raw material is etched by a wet etching process (S40). Accordingly, impurities adhering to the surface of the pulverized silicon carbide may be removed. In particular, the carbon-based material remaining in the pulverized silicon carbide raw material may float in the etchant and may react with hydrofluoric acid, etc. included in the etchant. Accordingly, in the wet etching process, not only metallic impurities but also the carbon-based material may be removed.

Next, the wet etched silicon carbide raw material is etched by a dry etching process (S50).

Next, the dry-etched silicon carbide raw material is subjected to a cleaning process (S60).

Next, the cleaned silicon carbide raw material may be classified into particles having a desired particle size (S70).

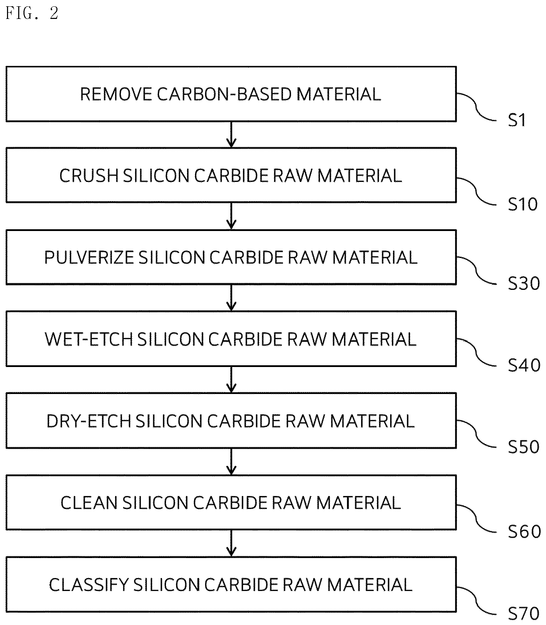

Referring to FIG. 2, a silicon carbide powder according to one embodiment may be manufactured by the following process.

In this embodiment, a process substantially the same as the process of FIG. 1 is carried out, but before the crushing process (S10), a carbon-based material removal process may be carried out (S1).

When the silicon carbide raw material contains a substantial amount of carbon as an impurity, the carbon-based material removal process may be preceded. For example, when the silicon carbide raw material includes a graphite component in a high ratio as in a graphite component coated with silicon carbide, the carbon-based material removal process may be performed first.

Since the carbon-based material is first removed (S1) and then the crushing process (S 10) is performed, the

10

carbon-based material included in the silicon carbide raw material may be efficiently removed.

Therefore, the method of manufacturing a silicon carbide powder according to the embodiment may provide a silicon carbide powder of high purity by using a silicon carbide raw material including a carbon-based material in a high content.

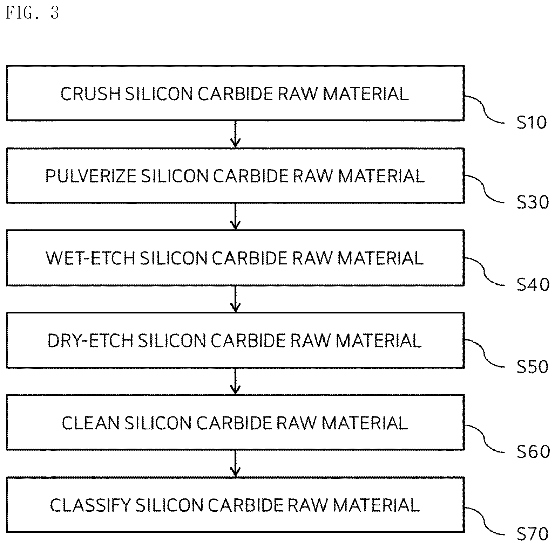

Referring to FIG. 3, a silicon carbide powder according to one embodiment may be manufactured by the following process.

In this embodiment, a process substantially the same as the process of FIG. 1 is carried out, but the carbon-based material removal process may be omitted.

When the silicon carbide raw material does not include the carbon-based material such as graphite or includes the same in a very low content, the carbon-based material removal process may be omitted. For example, the silicon carbide raw material may include silicon carbide in an amount of about 95 % by weight or more as in a monocrystal silicon carbide ingot, polycrystal silicon carbide, or a silicon carbide sintered body. In this case, in the wet etching process, etc., a small amount of carbon-based material is removed so that a silicon carbide powder with high purity may be obtained without a separate additional process.

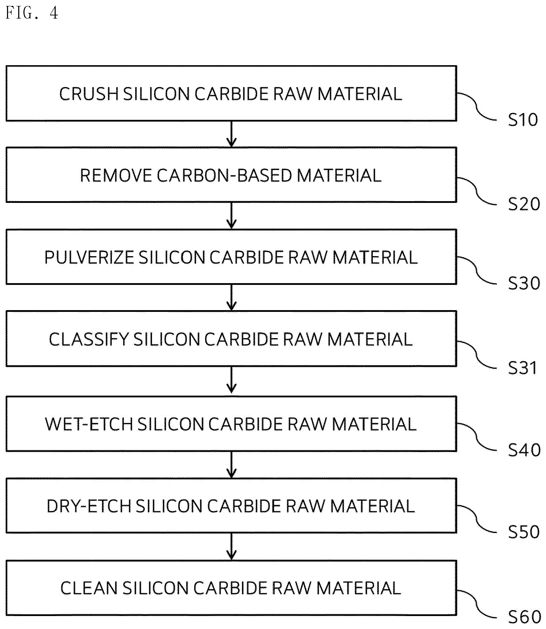

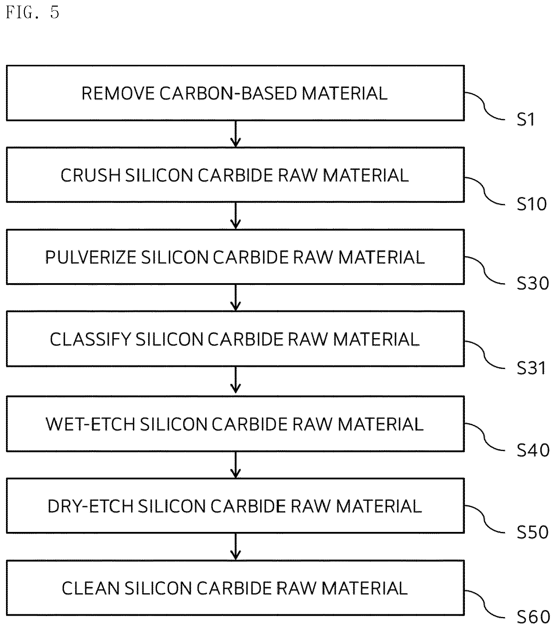

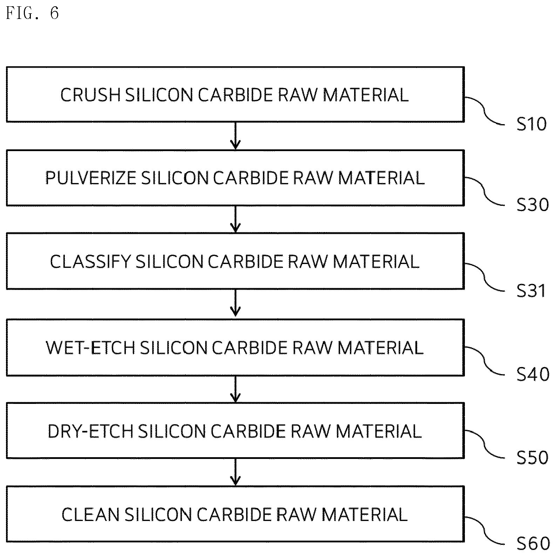

Referring to FIGS. 4 to 6, the silicon carbide powder according to one embodiment may be manufactured by the following process.

In this embodiment, a process substantially the same as the process of FIG. 1, 2, or 3 is carried out, but as shown in FIGs. 4, 5, and 6, the classification process (S31) may be performed immediately after the pulverization process (S30). That is, the pulverized silicon carbide raw material may be classified (divided up) into particles having a desired particle size by the classification process performed immediately after the pulverization process. Furthermore, the classified silicon carbide raw material may be subjected to the wet etching process, the dry etching process, and the cleaning process.

In the embodiments in FIGs. 4, 5, and 6, since the silicon carbide raw material is subjected to the wet etching process and the dry etching process after being classified (by particle size) into particles having a uniform particle diameter, the entire surface of the silicon carbide raw material may be uniformly etched. In particular, since the silicon carbide raw material is classified into particles having a uniform particle diameter, the space between the particles of the silicon carbide raw material may be uniformly formed. Accordingly, the etching gas may uniformly permeate into the space between the silicon carbide raw material particles, and the dry etching process may uniformly etch the silicon carbide raw materials as a whole.

Accordingly, the method of manufacturing a silicon carbide powder according to these embodiments may uniformly control the content of carbon, silicon, and oxygen included in the surface of the silicon carbide raw material as a whole.

The purity of the silicon carbide powder according to one embodiment obtained by the processes in FIGS. 4 to 6 may be about 99.99% or more. The purity of the silicon carbide powder according to an embodiment may be about 99.999% or more. The purity of the silicon carbide powder according to an embodiment may be about 99.9999% or more. The purity of the silicon carbide powder according to another embodiment may be about 99.999999% or more. The purity of the silicon carbide powder according to another embodiment may be about 99.9999999% or more. The purity of the silicon carbide powder according to another embodiment may be about 99.9999999% or more. The purity of the silicon carbide powder according to another embodiment may be about 99.99999999% or more.

The silicon carbide powder according to one embodiment may include at least one or more impurities selected from the group consisting of lithium, sodium, magnesium, aluminum, potassium, calcium, titanium, vanadium, chromium, manganese, iron, cobalt, nickel, copper, zinc, and molybdenum in an amount ranging from about 1 ppm or less, about 0.8 ppm or less, about 0.7 ppm or less, about 0.1 to about 0.7 ppm or about 0.1 to about 0.6 ppm.

In addition, the particle diameter (D50) of the silicon carbide powder according to one embodiment may range from about 10 $\mu$m to about 10000 $\mu$m. The particle diameter (D50) of the silicon carbide powder according to an embodiment may range from about 100 $\mu$m to about 6000 $\mu$m. The particle diameter (D50) of the silicon carbide powder according to an embodiment may range from about 60 $\mu$m to about 5000 $\mu$m. The particle diameter (D50) of the silicon carbide powder according to an embodiment may range from about 100 $\mu$m to about 4000 $\mu$m. The particle diameter (D50) of the silicon carbide powder according to an embodiment may range from about 150 $\mu$m to about 400 $\mu$m. The particle diameter (D50) of the silicon carbide powder according to an embodiment may range from about 300 $\mu$m to about 800 $\mu$m. The particle diameter (D50) of the silicon carbide powder according to an embodiment may range from about 500 $\mu$m to about 1000 $\mu$m. The particle diameter (D50) of the silicon carbide powder according to an embodiment may range from about 700 $\mu$m to about 2000 $\mu$m. The particle diameter (D50) of the silicon carbide powder according to an embodiment may range from about 1000 $\mu$m to about 3000 $\mu$m.

The silicon carbide powder according to one embodiment includes carbon and oxygen in an appropriate content ratio on the surface thereof. Accordingly, when a silicon carbide ingot and a silicon carbide wafer is made of the silicon carbide powder according to one embodiment, defects of the silicon carbide ingot and the silicon carbide wafer may be reduced because the content of the oxygen is appropriate.

In particular, since carbon and oxygen are included in an appropriate content ratio on the surface of the silicon carbide powder, the oxygen may be removed by reacting with the carbon in an initial heat treatment operation. Accordingly, oxygen on the surface of the silicon carbide powder may be removed in the initial heat treatment process, and defects in the process of growing the silicon carbide ingot may be minimized.

In addition, the oxygen reacts with the carbon and is removed as carbon dioxide, etc. In the process of removing the oxygen, the consumption amount of the carbon may be reduced. Accordingly, even after the oxygen is removed together with the carbon, the ratios of the silicon and the carbon may be appropriate throughout the silicon carbide powder. Accordingly, the silicon carbide powder according to one embodiment may minimize defects that may occur due to uneven content of the carbon and the silicon.

In addition, silicon and oxygen are contained in an appropriate content ratio on the surface of the silicon carbide powder according to one embodiment. Accordingly, the silicon carbide powder according to this embodiment may be effectively protected from external impurities. That is, the surface of the silicon carbide powder according to this embodiment may include a protective film containing oxygen and may be effectively protected from external chemical shocks.

In addition, the silicon carbide powder according to one embodiment may include the fluorine component as a by-product in the manufacturing process. Here, since the method of manufacturing a silicon carbide powder according to one embodiment includes the wet-etching process, the dry-etching process and the washing process, the content of the fluorine component is low. In addition, since the process of manufacturing a silicon carbide ingot according to one embodiment includes an initial heat treatment process for the silicon carbide powder, the fluorine component may be efficiently removed. That is, the fluorine component may be vaporized and removed in the initial heat treatment process.

The silicon carbide powder of the present disclosure may be used to manufacture a silicon carbide wafer having very high purity and improved performance.

A particle shape of the silicon carbide powder according to the embodiment may be analyzed through 2D image analysis.

The 2D image analysis may be performed by appropriately sampling the silicon carbide powder. For example, the silicon carbide powder according to one embodiment may be sampled in an amount of about 0.1g to about 10 g at a time and may be prepared for sampling of about 5 times to about 100 times, and the 2D image analysis may be performed for each sampling. Here, measurement values are derived through the 2D image analysis, and the feature of the silicon carbide powder according to this embodiment may be defined as an average value of the measurement values.

The sampled silicon carbide powder is scattered in the background. The background may have a color that is visually distinct from the silicon carbide powder. The scattered silicon carbide particles are respectively spaced apart from each other and are arranged so as not to overlap each other.

The particles contained in the silicon carbide powder according to this embodiment are photographed by an optical microscope, thereby obtaining a 2D image of the particles.

Next, the 2D image of the silicon carbide powder may be analyzed by image analysis software. iSolution series manufactured by Image & Microscope Technology (IMT) and the like can be used as an example of the image analysis software.

When the silicon carbide powder is analyzed by the 2D image analysis, the average area of particles contained in the silicon carbide powder of the present disclosure may range from about 50,000 $\mu m^2$ to 5,000,000 $\mu m^2$. When the silicon carbide powder is analyzed by the 2D image analysis, the average area of particles contained in the silicon carbide powder of the present disclosure may range from about 50,000 $\mu m^2$ to 100,000 $\mu m^2$. When the silicon carbide powder is analyzed by the 2D image analysis, the average area of particles contained in the silicon carbide powder of the present disclosure may range from about 150,000 $\mu m^2$ to 250,000 $\mu m^2$. When the silicon carbide powder of the present disclosure is analyzed by the 2D image analysis, the average area of particles contained in the silicon carbide powder may range from about 1,000,000 $\mu m^2$ to 2,000,000 $\mu m^2$. When the silicon carbide powder is analyzed by the 2D image analysis, the average area of particles contained in the silicon carbide powder of the present disclosure may range from about 2,500,000 $\mu m^2$ to 3,500,000 $\mu m^2$. When the silicon carbide powder is analyzed by the 2D image analysis, the average area of particles contained in the silicon carbide powder of the present disclosure may range from about 3,500,000 $\mu m^2$ to 5,000,000 $\mu m^2$.

When the silicon carbide powder is analyzed by the 2D image analysis, an average circumferential length of particles contained in the silicon carbide powder of the present disclosure may range from about 500 $\mu m$ to about 10 mm. When the silicon carbide powder is analyzed by the 2D image analysis, the average circumferential length of particles contained in the silicon carbide powder of the present disclosure may range from about 500 $\mu m$ to about 1.5 mm. When the silicon carbide powder is analyzed by the 2D image analysis, the average circumferential length of particles contained in the silicon carbide powder of the present disclosure may range from about 1.5 mm to about 2.5 mm. When the silicon carbide powder is analyzed by the 2D image analysis, the average circumferential length of particles contained in the silicon carbide powder of the present disclosure may range from about 4 mm to about 6 mm. When the silicon carbide powder according to the embodiment, the average circumferential length of particles contained in the silicon carbide powder of the present disclosure may range from about 7 mm to about 10 mm.

When the silicon carbide powder is analyzed by the 2D image analysis, a mean equivalent circle diameter of particles contained in the silicon carbide powder of the present disclosure may range from about 150 $\mu$m to about 3 mm. The equivalent circle diameter is calculated based on an area. That is, assuming a circle equal to the area, the equivalent circle diameter may mean the diameter of the circle. When the silicon carbide powder is analyzed by the 2D image analysis, the mean equivalent circle diameter of particles contained in the silicon carbide powder of the present disclosure may range from about 150 $\mu$m to about 300 $\mu$m. When the silicon carbide powder is analyzed by the 2D image analysis, the mean equivalent circle diameter of particles contained in the silicon carbide powder of the present disclosure may range from about 300 $\mu$m to about 700 $\mu$m. When the silicon carbide powder is analyzed by the 2D image analysis, the mean equivalent circle diameter of particles contained in the silicon carbide powder of the present disclosure may range from about 1000 $\mu$m to about 1500 $\mu$m. When the silicon carbide powder is analyzed by the 2D image analysis, the mean equivalent circle diameter of particles contained in the silicon carbide powder of the present disclosure may range from about 1500 $\mu$m to about 2300 $\mu$m. When the silicon carbide powder is analyzed by the 2D image analysis, the mean equivalent circle diameter of particles contained in the silicon carbide powder of the present disclosure may range from about 2000 $\mu$m to about 2500 $\mu$m.

When the silicon carbide powder is analyzed by the 2D image analysis, an average maximum elliptical diameter of particles contained in the silicon carbide powder of the present disclosure may range from about 300 $\mu$m to about 3500 $\mu$m. When the silicon carbide powder is analyzed by the 2D image analysis, the average maximum elliptical diameter of particles contained in the silicon carbide powder of the present disclosure may range from about 300 $\mu$m to about 400 $\mu$m. When the silicon carbide powder is analyzed by the 2D image analysis, the average maximum elliptical diameter of particles contained in the silicon carbide powder of the present disclosure may range from about 600 $\mu$m to about 750 $\mu$m. When the silicon carbide powder is analyzed by the 2D image analysis, the average maximum elliptical diameter of particles contained in the silicon carbide powder of the present disclosure may range from about 1000 $\mu$m to about 2000 $\mu$m. When the silicon carbide powder is analyzed by the 2D image analysis, the average maximum elliptical diameter of particles contained in the silicon carbide powder of the present disclosure may range from about 2500 $\mu$m to about 3500 $\mu$m. When the silicon carbide powder is analyzed by the 2D image analysis, the average maximum elliptical diameter of particles contained in the silicon carbide powder of the present disclosure may range from about 550 $\mu$m to about 800 $\mu$m.

When the silicon carbide powder is analyzed by the 2D image analysis, an average minimum elliptical diameter of particles contained in the silicon carbide powder of the present disclosure may range from about 150 $\mu$m to about 2500 $\mu$m. When the silicon carbide powder is analyzed by the 2D image analysis, the average minimum elliptical diameter of particles contained in the silicon carbide powder of the present disclosure may range from about 150 $\mu$m to about 250 $\mu$m. When the silicon carbide powder is analyzed by the 2D image analysis, the average minimum elliptical diameter of particles contained in the silicon carbide powder of the present disclosure may range from about 300 $\mu$m to about 500 $\mu$m. When the silicon carbide powder is analyzed by the 2D image analysis, the average minimum elliptical diameter of particles contained in the silicon carbide powder of the present disclosure may range from about 850 $\mu$m to about 1300 $\mu$m. When the silicon carbide powder is analyzed by the 2D image analysis, the average minimum elliptical diameter of particles contained in the silicon carbide powder of the present disclosure may range from about 1300 $\mu$m to about 1900 $\mu$m. When the silicon carbide powder is analyzed by the 2D image analysis, the average minimum elliptical diameter of particles contained in the silicon carbide powder of the present disclosure may range from about 1700 $\mu$m to about 2500 $\mu$m.

When the silicon carbide powder is analyzed by the 2D image analysis, an average maximum length of particles contained in the silicon carbide powder of the present disclosure may range from about 250 $\mu$m to about 3000 $\mu$m. Here, the maximum length may mean a length in the longest direction in a 2D image of each particle. When the silicon carbide powder is analyzed by the 2D image analysis, the average maximum length of particles contained in the silicon carbide powder of the present disclosure may range from about 250 $\mu$m to about 400 $\mu$m. When the silicon carbide powder is analyzed by the 2D image analysis, the average maximum length of particles contained in the silicon carbide powder of the present disclosure may range from about 500 $\mu$m to about 800 $\mu$m. When the silicon carbide powder is analyzed by the 2D image analysis, the average maximum length of particles contained in the silicon carbide powder of the present disclosure may range from about 1300 $\mu$m to about 1800 $\mu$m. When the silicon carbide powder is analyzed by the 2D image analysis, the average maximum length of particles contained in the silicon carbide powder of the present disclosure may range from about 1700 $\mu$m to about 2300 $\mu$m. When the silicon carbide powder is analyzed by the 2D image analysis, the average maximum length of particles contained in the silicon carbide powder of the present disclosure may range from about 2200 $\mu$m to about 3000 $\mu$m.

When the silicon carbide powder is analyzed by the 2D image analysis, an average maximum frame diameter of the particles contained in the silicon carbide powder of the present disclosure may range from about 300 $\mu$m to about 3500 $\mu$m. The image of the captured particles may be measured with a virtual vernier caliper while rotating. Here, the maximum frame diameter may mean the largest width of the measured widths. When the silicon carbide powder is analyzed by the 2D image analysis, the average maximum frame diameter of the particles contained in the silicon carbide powder of the present disclosure may range from about 300 μm to about 450 μm. When the silicon carbide powder is analyzed by the 2D image analysis, the average maximum frame diameter of the particles contained in the silicon carbide powder of the present disclosure may range from about 500 μm to about 900 μm. When the silicon carbide powder is analyzed by the 2D image analysis, the average maximum frame diameter of the particles contained in the silicon carbide powder of the present disclosure may range from about 1300 μm to about 2000 μm. When the silicon carbide powder is analyzed by the 2D image analysis, the average maximum frame diameter of the particles contained in the silicon carbide powder of the present disclosure may range from about 2200 μm to about 2600 μm. When the silicon carbide powder is analyzed by the 2D image analysis, the average maximum frame diameter of the particles contained in the silicon carbide powder of the present disclosure may range from about 2700 μm to about 3500 μm.

When the silicon carbide powder is analyzed by the 2D image analysis, an average minimum frame diameter of the particles contained in the silicon carbide powder of the present disclosure may range from about 150 μm to about 2200 μm. The image of the captured particles may be measured with a virtual vernier caliper while rotating. Here, the minimum frame diameter may mean the smallest width of the measured widths. When the silicon carbide powder is analyzed by the 2D image analysis, the average minimum frame diameter of the particles contained in the silicon carbide powder of the present disclosure may range from about 150 μm to about 280 μm. When the silicon carbide powder is analyzed by the 2D image analysis, the average minimum frame diameter of the particles contained in the silicon carbide powder of the present disclosure may range from about 350 μm to about 450 μm. When the silicon carbide powder is analyzed by the 2D image analysis, the average minimum frame diameter of the particles contained in the silicon carbide powder of the present disclosure may range from about 750 μm to about 1250 μm. When the silicon carbide powder is analyzed by the 2D image analysis, the average minimum frame diameter of the particles contained in the silicon carbide powder of the present disclosure may range from about 1300 μm to about 1800 μm. When the silicon carbide powder is analyzed by the 2D image analysis, the average minimum frame diameter of the particles contained in the silicon carbide powder of the present disclosure may range from about 1800 μm to about 2200 μm.

When the silicon carbide powder is analyzed by the 2D image analysis, the average minimum frame diameter of the particles contained in the silicon carbide powder of the present disclosure may range from about 250 μm to about 2700 μm. The image of the captured particles may be measured with a virtual vernier caliper while rotating. Here, the middle frame diameter may mean the average of measured widths. When the silicon carbide powder is analyzed by the 2D image analysis, the average minimum frame diameter of the particles contained in the silicon carbide powder of the present disclosure may range from about 250 μm to about 350 μm. When the silicon carbide powder is analyzed by the 2D image analysis, the average minimum frame diameter of the particles contained in the silicon carbide powder of the present disclosure may range from about 400 μm to about 600 μm. When the silicon carbide powder is analyzed by the 2D image analysis, the average minimum frame diameter of the particles contained in the silicon carbide powder of the present disclosure may range from about 1250 μm to about 1700 μm. When the silicon carbide powder is analyzed by the 2D image analysis, the average minimum frame diameter of the particles contained in the silicon carbide powder of the present disclosure may range from about 1800 μm to about 2200 μm. When the silicon carbide powder is analyzed by the 2D image analysis, the average minimum frame diameter of the particles contained in the silicon carbide powder of the present disclosure may range from about 2300 μm to about 2700 μm.

When the silicon carbide powder is analyzed by the 2D image analysis, an average convex hull of the particles contained in the silicon carbide powder of the present disclosure may be about 700 μm to about 10000 μm. When the silicon carbide powder is analyzed by the 2D image analysis, the average convex hull of the particles contained in the silicon carbide powder of the present disclosure may range from about 700 μm to about 1300 μm. When the silicon carbide powder is analyzed by the 2D image analysis, the average convex hull of the particles contained in the silicon carbide powder of the present disclosure may range from about 1600 μm to about 2200 μm. When the silicon carbide powder is analyzed by the 2D image analysis, the average convex hull of the particles contained in the silicon carbide powder of the present disclosure may range from about 4000 μm to about 5000 μm. When the silicon carbide powder is analyzed by the 2D image analysis, the average convex hull of the particles contained in the silicon carbide powder of the present disclosure may range from about 6000 μm to about 7000 μm. When the silicon carbide powder is analyzed by the 2D image analysis, the average convex hull of the particles contained in the silicon carbide powder of the present disclosure may range from about 7000 μm to about 9000 μm.

When the silicon carbide powder is analyzed by the 2D image analysis, an average particle circularity of the particles contained in the silicon carbide powder of the present disclosure may range from 0.4 to 0.9. When the silicon carbide powder is analyzed by the 2D image analysis, the average particle circularity of the particles contained in the silicon carbide powder of the present disclosure may range from 0.4 to 0.8. When the silicon carbide powder is analyzed by the 2D image analysis, the average particle circularity of the particles contained in the silicon carbide powder of the present disclosure may range from 0.45 to 0.75. When the silicon carbide powder is analyzed by the 2D image analysis, the average particle circularity of the particles contained in the silicon carbide powder of the present disclosure may range from 0.5 to 0.7. When the silicon carbide powder is analyzed by the 2D image analysis, the average particle circularity of the particles contained in the silicon carbide powder of the present disclosure may range from 0.55 to 0.7.

The particle circularity may be calculated according to the following equation:

Equation 1

$$\text{Particle circularity} = 4 \times \pi \times \text{particle area} / (\text{circumference})^2$$

When the silicon carbide powder is analyzed by the 2D image analysis, an average particle ellipticity of the particles contained in the silicon carbide powder of the present disclosure may range from 0.85 to 1. When the silicon carbide powder is analyzed by the 2D image analysis, the average particle ellipticity of the particles contained in the silicon carbide powder of the present disclosure may range from 0.90 to 1. When the silicon carbide powder is analyzed by the 2D image analysis, the average particle ellipticity of the particles contained in the silicon carbide powder of the present disclosure may range from 0.91 to 1. When the silicon carbide powder is analyzed by the 2D image analysis, the average particle ellipticity of the particles contained in the silicon carbide powder of the present disclosure may range from 0.93 to 1. In one embodiment, tje particle ellipticity measured through the 2D image analysis may be 0.92 or more.

When the silicon carbide powder is analyzed by the 2D image analysis, an average particle convexity of the particles contained in the silicon carbide powder of the present disclosure may range from about 0.83 to about 0.99.

The particle convexity may be calculated by Equation 2 below:

Equation 2

$$\text{Particle convexity} = \text{Convex hull} / \text{circumference}$$

When the silicon carbide powder is analyzed by the 2D image analysis, the average particle convexity of the particles contained in the silicon carbide powder of the present disclosure may range from about 0.83 to about 0.99. When the silicon carbide powder is analyzed by the 2D image analysis, the average particle convexity of the particles contained in the silicon carbide powder of the present disclosure may range from about 0.84 to about 0.98. When the silicon carbide powder is analyzed by the 2D image analysis, the average particle convexity of the particles contained in the silicon carbide powder of the present disclosure may range from about 0.85 to about 0.95. When the silicon carbide powder is analyzed by the 2D image analysis, the average particle convexity of the particles contained in the silicon carbide powder of the present disclosure may range from about 0.86 to about 0.94. In one embodiment, a particle convexity measured through the 2D image analysis may range from 0.9 to 0.99.

When the silicon carbide powder is analyzed by the 2D image analysis, an average particle elongation of the particles contained in the silicon carbide powder of the present disclosure may be about 0.8 to about 0.95.

The particle elongation may be calculated by Equation 3 below:

Equation 3

$$\text{Particle elongation} = \text{Equivalent circle diameter} / \text{maximum length}$$

As the particle elongation approaches 1, the 2D image of the particles shows a converging shape, and as the particle elongation approaches 0, the 2D image of the particles shows an elongated shape.

When the silicon carbide powder is analyzed by the 2D image analysis, the average particle elongation of the particles contained in the silicon carbide powder of the present disclosure may range from about 0.81 to about 0.95. When the silicon carbide powder is analyzed by the 2D image analysis, the average particle elongation of the particles contained in the silicon carbide powder of the present disclosure may range from about 0.82 to about 0.94. When the silicon carbide powder is analyzed by the 2D image analysis, the average particle elongation of the particles contained in the silicon carbide powder of the present disclosure may range from about 0.83 to about 0.93.

The silicon carbide powder according to one embodiment may have a flow index.

The flow index may be measured by the following method.

The silicon carbide powder of the present disclosure may have a flow index ranging from about 0.01 to about 0.7 under a major principal consolidation stress of about 0.3 kPa. The silicon carbide powder of the present disclosure may have a flow index ranging from about 0.01 to about 0.5 under a major principal consolidation stress of about 0.3 kPa. The silicon carbide powder of the present disclosure may have a flow index ranging from about 0.02 to about 0.3 under a major principal consolidation stress of about 0.3 kPa. The silicon carbide powder of the present disclosure may have a flow index ranging from about 0.02 to about 0.2 under a major principal consolidation stress of about 0.3 kPa. The silicon carbide powder of the present disclosure may have a flow index ranging from about 0.02 to about 0.15 under a major principal consolidation stress of about 0.3 kPa.

The silicon carbide powder of the present disclosure may have a flow index ranging from about 0.001 to about 0.5 under a major principal consolidation stress of about 9 kPa. The silicon carbide powder of the present disclosure may have a flow index ranging from about 0.005 to about 0.4 under a major principal consolidation stress of about 9 kPa. The silicon carbide powder of the present disclosure may have a flow index ranging from about 0.01 to about 0.1 under a major principal consolidation stress of about 9 kPa. The silicon carbide powder of the present disclosure may have a flow index ranging from about 0.02 to about 0.1 under a major principal consolidation stress of about 9 kPa. The silicon carbide powder of the present disclosure may have a flow index ranging from about 0.03 to about 0.1 under a major principal consolidation stress of about 9 kPa.

The flow index may be calculated by Equation 4 below:

$$\text{Equation 4}$$

$$FI = UFS/MPCS$$

where FI represents a flow index, and UFS represents the unconfined failure strength of a mold formed by compressing the silicon carbide powder according to the embodiment with a major principal consolidation stress.

The unconfined failure strength may be measured by the following method.

To measure the unconfined failure strength, the silicon carbide powder of the present disclosure is filled into a circular frame having a specific diameter and a specific height. Next, the major principal consolidation stress is uniformly applied in a vertical direction of the circular frame to the silicon carbide powder filled in the circular frame. Accordingly, an agglomerated silicon carbide powder pillar is formed in the circular frame.

The circular frame may have a diameter ranging from about 10 mm to about 500 mm. The circular frame may have a height ranging from about 10 mm to about 500 mm.

The circular frame may have a diameter ranging from about 50 mm to about 200 mm. The circular frame may have a height ranging from about 50 mm to about 200 mm.

The circular frame may have a diameter ranging from about 50 mm to about 150 mm. The circular frame may have a height ranging from about 50 mm to about 150 mm.

Next, the circular frame is removed, and a pressure is uniformly applied onto the agglomerated silicon carbide powder pillar. The pressure applied onto the agglomerated silicon carbide powder pillar is gradually increased. Next, a pressure when the agglomerated silicon carbide powder pillar collapses is measured. The pressure when the agglomerated silicon carbide powder pillar collapses is the unconfined failure strength.

The unconfined failure strength may be measured using a Powder Flow Tester manufactured by Brookfield.

The silicon carbide powder of the present disclosure may have an unconfined failure strength ranging from about 0.005 kPa to about 0.05 kPa under a major principal consolidation stress of about 0.3 kPa. The silicon carbide powder of the present disclosure may have an unconfined failure strength ranging from about 0.005 kPa to about 0.04 kPa under a major principal consolidation stress of about 0.3 kPa. The silicon carbide powder of the present disclosure may have an unconfined failure strength ranging from about 0.007 kPa to about 0.035 kPa under a major principal consolidation stress of about 0.3 kPa.

The silicon carbide powder of the present disclosure may have an unconfined failure strength ranging from about 0.1 kPa to about 2 kPa under a major principal consolidation stress of about 9 kPa. The silicon carbide powder of the present disclosure may have an unconfined failure strength ranging from about 0.1 kPa to about 1.5 kPa under a major principal consolidation stress of about 9 kPa. The silicon carbide powder of the present disclosure may have an unconfined failure strength ranging from about 0.1 kPa to about 1 kPa under a major principal consolidation stress of about 9 kPa. The silicon carbide powder of the present disclosure may have an unconfined failure strength ranging from about 0.15 kPa to about 1 kPa under a major principal consolidation stress of about 9 kPa.

The silicon carbide powder of the present disclosure may have an unconfined failure strength per average particle diameter according to Equation 5 below:

$$\text{Equation 5}$$

$$UFSPD = UFS/D$$

where UFSPD represents an unconfined failure strength per average particle diameter, and D represents an average particle diameter of the silicon carbide powder according to this embodiment.

In the silicon carbide powder according to this embodiment, the unconfined failure strength per average particle diameter may range from about 0.001 Pa/$\mu$m to about 0.3 Pa/$\mu$m under a major principal consolidation stress of about 0.3 kPa. In the silicon carbide powder according to this embodiment, the unconfined failure strength per average particle diameter may range from about 0.002 Pa/$\mu$m to about 0.25 Pa/$\mu$m under a major principal consolidation stress of about 0.3 kPa.

In the silicon carbide powder according to this embodiment, the unconfined failure strength per average particle diameter may range from about 0.05 Pa/$\mu$m to about 7 Pa/$\mu$m under a major principal consolidation stress of about 9 kPa. In the silicon carbide powder according to this embodiment, the unconfined failure strength per average particle diameter may range from about 0.1 Pa/$\mu$m to about 6 Pa/$\mu$m under a major principal consolidation stress of about 9 kPa.

The silicon carbide powder according to one embodiment may have a repose angle.

The repose angle of the silicon carbide powder according to this embodiment may range from about 20° to about 45°. The repose angle of the silicon carbide powder according to this embodiment may range from about 25° to about 45°. The repose angle of the silicon carbide powder according to this embodiment may range from about 25° to about 40°.

The repose angle may be measured by the following method:
The silicon carbide powder of the present disclosure is poured into a circular plate having a diameter of about 100 mm, and the silicon carbide powder is deposited in a conical shape to form a deposited layer. The repose angle may be an angle between the horizontal plane and the slope of the sedimentary layer.

The silicon carbide powder of the present disclosure may have a tap density.

The tap density of the silicon carbide powder according to this embodiment may range from about 1.3g/cm$^3$ to about 2.5g/cm$^3$. The tap density of the silicon carbide powder according to this embodiment may range from about 1.5g/cm$^3$ to about 2.0 g/cm$^3$. The tap density of the silicon carbide powder according to this embodiment may range from about 1.5g/cm$^3$ to about 1.8g/cm$^3$.

The tap density may be measured by the following method.

The tap density may be measured using a tap density measurement instrument.

The silicon carbide powder of the present disclosure about 100 g is filled into a 250 ml cylinder. Next, the cylinder is tapped until the volume of the silicon carbide powder is reduced by about 2%. Here, the apparent density of the silicon carbide powder measure by weight of the powder poured in the cylinder divided by the reduced volume according to this embodiment may be the tap density.

The silicon carbide powder according to one embodiment may have a flow index per average particle diameter (D50).

The flow index per average particle diameter may be derived by Equation 6 below:

$$\text{Equation 6}$$

$$FIPD = FI/D$$

where FIPD represents a flow index per average particle diameter, FI represents a flow index of the silicon carbide powder according to the embodiment, and D represents an average particle diameter (D50) of the silicon carbide powder according to thos embodiment.

The silicon carbide powder of the present disclosure may have a flow index of less than about 0.0007/$\mu$m per the average particle diameter (D50) under a major principal consolidation stress of about 0.3 kPa.

The silicon carbide powder according to this embodiment may have a flow index of less than about 0.0006/$\mu$m per the average particle diameter (D50) under a major principal consolidation stress of about 9 kPa.

In addition, the flow index under a major principal consolidation stress of 0.3 kPa relative to the flow index under a major principal consolidation stress of 9 kPa may range from 0.5 to 3. The flow index under a major principal consolidation stress of 0.3 kPa relative to the flow index under a major principal consolidation stress of 9 kPa may range from 1 to 4. The flow index under a major principal consolidation stress of 0.3 kPa relative to the flow index under a major principal consolidation stress of 9 kPa may range from 1 to 3.

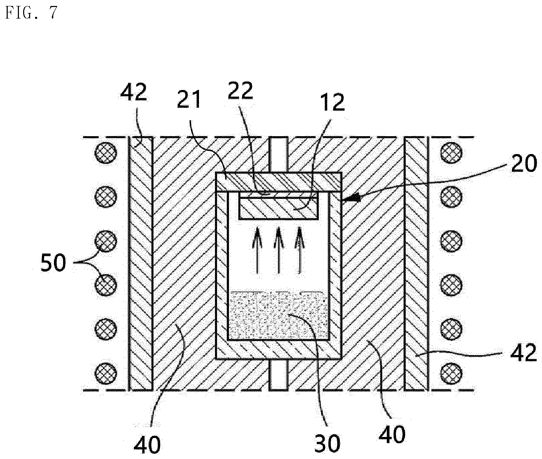

Referring to FIG. 7, a silicon carbide wafer according to one embodiment may be manufactured as follows.

First, when a silicon carbide ingot is manufactured, the silicon carbide ingot is manufactured by applying the physical vapor transport (PVT) method to produce a silicon carbide ingot have a large area and few defects.

A method of manufacturing a silicon carbide ingot 12 according to this embodiment may include a preparation operation, a silicon carbide powder-loading operation and a growth operation.

The preparation operation is an operation of preparing a crucible assembly including a crucible body 20 having an inner space and a crucible cover 21 for covering the crucible body.

The silicon carbide powder-loading operation is an operation of loading a silicon carbide powder 30 in the crucible assembly and placing a seed tablet on the raw material at a certain distance from the raw material.

The crucible body 20 may have, for example, a cylindrical shape having an open upper surface and a structure in which a silicon carbide raw material may be loaded. The crucible body 20 may have a density ranging from 1.70 g/cm$^3$ to 1.90 g/cm$^3$. A material of the crucible body 20 may include graphite.

The crucible cover 21 may be a density ranging from 1.70 g/cm$^3$ to 1.90 g/cm$^3$. The material of the crucible cover 21 may include graphite. The crucible cover 21 may cover the entire opening of the crucible body 20.

The crucible cover 21 may cover a portion of the opening of the crucible body 20 or include a through hole. The rate of vapor transfer in a crystal growth atmosphere to be described later may be adjusted.

In addition, a seed tablet holder 22 is disposed on the crucible cover 21. The seed tablet holder 22 may be coupled to the crucible cover 21. The seed tablet holder 22 may be attached to the crucible cover 21. The seed tablet holder 22 may be integrally formed with the crucible cover 21.

The thickness of the crucible cover 21 may range from about 10 mm to about 50 mm. In addition, the thickness of the seed tablet holder 22 may range from about 1 mm to about 10 mm.

To manufacture the silicon carbide ingot, a seed tablet was prepared. The seed tablet may be any one of silicon carbide wafers to which an off angle, which is an angle selected from a range ranging from 0 to 8 degrees with respect to the (0001) plane, is applied.

The seed tablet may be a 4H SiC ingot that is a substantially single crystal with minimal defects or polymorphic inclusions. The silicon carbide seed tablet may be substantially made of 4H SiC.

The seed tablet may have a diameter of 4 inches or more, 5 inches or more, even 6 inches or more. More specifically, the seed tablet may have a diameter ranging from 4 to 12 inches, 4 to 10 inches, or 6 to 8 inches.

The seed tablet is attached to a seed tablet holder. The seed tablet holder contains graphite. The seed tablet holder may be made of graphite. The seed tablet holder may include anisotropic graphite. In more detail, the seed tablet holder may be formed of anisotropic graphite.

In addition, the seed tablet and the seed tablet holder are adhered to each other by an adhesive layer. The adhesive layer includes a graphite filler and a carbide such as a phenolic resin. The adhesive layer may have a low porosity.

The C surface (0001) side of the silicon carbide seed tablet may be placed facing downward.

Next, the silicon carbide powder according to the embodiment was loaded to manufacture the silicon carbide ingot in the crucible.

A silicon carbide powder 30 includes a carbon source and a silicon source. Specifically, the silicon carbide powder 30 includes a carbon-silicon source. The silicon carbide powder 30 may have the characteristics described above.

When the silicon carbide powder 30 is loaded in the crucible, the bulk density of the silicon carbide powder 30 may range from about 1400 kg/m$^3$ to about 1700 kg/m$^3$. When the silicon carbide powder 30 is loaded in the crucible, the bulk density of the silicon carbide powder 30 may range from about 1500 kg/m$^3$ to about 1650 kg/m$^3$.

The silicon carbide powder 30 having a particle size of 75 um or less may be included in an amount of 15 % by weight or less, 10 % by weight or less, or 5 % by weight or less based on the total raw material. When a raw material includes small particles in a relatively small content, a silicon carbide ingot that can reduce the occurrence of defects in an ingot, is more advantageous in controlling supersaturation, and can provide a wafer with improved crystal characteristics may be manufactured.

The silicon carbide powder 30 may be necked or non-necked to each other. When a raw material having the particle diameter is applied, a silicon carbide ingot that can provide a wafer with better crystal characteristics may be manufactured.

In the silicon carbide powder-loading operation, the crucible assembly may have a weight ratio (Rw) that is 1.5 to 2.7 times the weight of the silicon carbide powder 3 when the weight of the silicon carbide powder 30 is normalized to 1. Here, the weight of the crucible assembly means the weight of the crucible assembly excluding the raw material. Specifically, the weight of the crucible assembly is a value obtained by excluding the weight of an added raw material from the weight of the crucible assembly including a seed tablet, regardless of whether a seed holder is applied to the crucible assembly.

If the weight ratio is less than 1.5, supersaturation increases excessively in the crystal growth atmosphere, so that the crystal quality of the ingot may rather deteriorate. If the weight ratio exceeds 2.7, supersaturation decreases so that the crystal quality of the ingot may deteriorate.

The weight ratio may range from 1.6 to 2.6 or 1.7 to 2.4. Within these weight ratios, an ingot with excellent defect characteristics and crystallinity characteristics may be manufactured.

When the diameter of the inner space of the crucible body 20 is normalized to 1, the length ratio, which is a ratio of the length from the bottom surface, where the silicon carbide powder 30 is located, of the crucible assembly to the surface of a seed tablet 11, may be greater than 1 times and less than 25 times.

The growth operation is an operation in which the inner space of the crucible body 20 is adjusted to a crystal growth atmosphere to vapor-transfer and deposit the raw material to the seed tablet and prepare a silicon carbide ingot grown from the seed tablet.

The growth operation may include an operation of adjusting the inner space of the crucible assembly to a crystal growth atmosphere. Specifically, a reaction vessel containing the crucible assembly and the insulator surrounding the crucible assembly may be prepared by wrapping the crucible assembly with an insulator 40, and the crucible, etc. may be heated using a heating device 50 after placing the reaction vessel in a reaction chamber such as a quartz tube.

The reaction vessel was placed in a reaction chamber 42, and the inner space of the crucible body 20 was brought to a temperature suitable for a crystal growth atmosphere using a heating device 50. This temperature is one of the important factors for the crystal growth atmosphere and forms a more suitable crystal growth atmosphere by adjusting conditions such as pressure and gas movement. The insulator 40 may be located between the reaction chamber 42 and the reaction vessel to facilitate the formation and control of the crystal growth atmosphere.

The insulator 40 may affect the temperature gradient inside the crucible body or the reaction vessel in a growing atmosphere. Specifically, the insulator may include a graphite insulator. More specifically, the insulator may include a rayon-based graphite felt or a pitch-based graphite felt.

In an embodiment, the insulator may have a density ranging from about 0.12 g/cc to about 0.30 g/cc. In an embodiment, the insulator may have a density ranging from about 0.13 g/cc to about 0.25 g/cc. In an embodiment, the insulator may have a density ranging from about 0.14 g/cc to about 0.20 g/cc.

When the density of the insulator is less than about 0.14 g/cc, an ingot may grow in a concave shape, and 6H-SiC polymorphism may occur, thereby deteriorating the quality of the ingot.

When the density of the insulator exceeds about 0.30 g/cc, an ingot may grow excessively convex, and the growth rate of the edges thereof may decrease, which may decrease the yield or increase the occurrence of cracks in the ingot.

When an insulator having a density ranging from about 0.12 g/cc to about 0.30 g/cc is applied, the quality of the ingot may be improved. When an insulator having a density ranging from about 0.14 g/cc to about 0.20 g/cc is applied, a crystal growth atmosphere may be controlled in an ingot growth process and an ingot of better quality may be grown.

The insulator may have a porosity ranging from about 73 vol% to about 95 vol%. The insulator may have a porosity ranging from about 76 vol% to about 93 vol%%. The insulator may have a porosity ranging from 81 vol% to 91 vol%. When an insulator having such porosity is applied, the frequency of cracks in the ingot may be further reduced.

The insulator may have a compressive strength of about 0.21 Mpa or more. The insulator may have a compressive strength of about 0.49 Mpa or more. The insulator may have a compressive strength of about 0.78 MPa or more. In addition, the insulator may have a compressive strength of about 3 MPa or less or a compressive strength of about 25 MPa or less. When the insulator has such a compressive strength, excellent thermal/mechanical stability is exhibited, and iSiC ingots of better quality may be manufactured because the probability of ash is reduced.

The insulator may have a thickness of about 20 mm or more or a thickness of about 30 mm or more. In addition, the insulator may have a thickness of about 150 mm or less, a thickness of about 120 mm or less, or a thickness of about 80 mm or less. When the thickness of the insulator falls within the above ranges, sufficient insulation effect may be obtained without unnecessary waste of an insulator.

The insulator 40 may have a density ranging from about 0.12 g/cc to about 0.30 g/cc. The insulator 40 may have a porosity ranging from about 72 vol% to about 90 vol%. When such an insulator is applied, it is possible to suppress the shape of an ingot from growing concave or excessively convex, and it is possible to reduce the deterioration of polymorphic quality or the occurrence of cracks in the ingot.

The crystal growth atmosphere may be implemented by heating the heating device 500 outside the reaction chamber 42, the air may be removed by reducing the pressure simultaneously with or separately from the heating, and a reduced pressure atmosphere and/or an inert atmosphere (e.g., Ar atmosphere, N2 atmosphere or a mixture thereof) may be implemented.

The crystal growth atmosphere induces the growth of a silicon carbide crystal by allowing a raw material to vapor-transfer on the surface of a seed tablet to grow into the ingot 100.

The crystal growth atmosphere may be implemented under conditions such as a growth temperature ranging from 2100 °C to 2450 °C and a growth pressure ranging from 1 Torr to 100 Torr. When such a temperature and pressure are applied, a silicon carbide ingot may be more efficiently manufactured.

Specifically, in the crystal growth atmosphere, the upper and lower surface temperatures as the growth temperature of the crucible may range from 2100 °C to 2450 °C and the growth pressure thereof may range from 1 Torr to 50 Torr. More specifically, the upper and lower surface temperatures as the growth temperature of the crucible may range from 2150 °C to 2450 °C and the growth pressure thereof may be 1 Torr to 40 Torr.

More specifically, the upper and lower surface temperatures as the growth temperature of the crucible may range from 2150 °C to 2350 °C and the growth pressure thereof may be 1 Torr to 30 Torr.

The manufacturing method of the present disclosure can more advantageously manufacture a higher-quality silicon carbide ingot by applying the crystal growth atmosphere described above.

The silicon carbide ingot 12 contains 4H SiC and may have a convex or flat surface.

If the surface of the silicon carbide ingot 12 is formed in a concave shape, other polytypes, such as 6H-SiC, in addition to the intended 4H-SiC crystal may be mixed, which may degrade the quality of the silicon carbide ingot. In addition, the surface of the silicon carbide ingot is formed in an excessively convex shape, cracks may occur in the ingot itself or crystals may be broken when processed into wafers.

Here, whether the silicon carbide ingot 12 is an excessively convex ingot is determined based on the degree of warp, and a silicon carbide ingot manufactured in this specification has a warp of ranging from 20 mm or less.

The warp is evaluated as a value of (center height - edge height) by placing a sample, on which the growth of a silicon carbide ingot is completed, on a surface plate and measuring the heights of the center and edge of the ingot based on the back of the ingot with a height gauge. A positive value of warp means convex, a value of 0 means flat, and a negative value means concave.

Specifically, the silicon carbide ingot 12 may have a convex or flat surface and a warp ranging from 0 mm to about 14 mm, a warp ranging from about 0 mm to about 11 mm, or a warp ranging from about 0 mm to about 8. A silicon carbide ingot with such a warp degree can make wafer processing easier and reduce the occurrence of cracks.

The silicon carbide ingot 12 may be a 4H SiC ingot that is a substantially single crystal with minimized defects or polymorphic mixing. The silicon carbide ingot 12 may be formed of substantially 4H SiC and may have a convex or flat surface.

The silicon carbide ingot 12 may reduce defects that can occur in a silicon carbide ingot, and provide a higher-quality silicon carbide wafer.

The silicon carbide ingot manufactured by the method of the present specification may reduce the pit density on the surface thereof. Specifically, the pit density the surface of an ingot with a diameter of 4 inches or more may be about 10 k/cm$^2$ or less.

In this specification, to evaluate the surface pit of the silicon carbide ingot, a total of 5 locations, i.e., one location in the center of the ingot surface excluding facets and four locations at 3 o'clock, 6 o'clock, 9 o'clock, and 12 o'clock directions located approximately 10 mm inside from the edge of the silicon carbide ingot toward the center, is observed with an optical microscope, and the pit per unit area (1 cm$^2$) is measured at each location, and the average value thereof is obtained.

For example, the outer rim of the silicon carbide ingot may be trimmed using external grinding equipment, sliced to a certain thickness, and subjected to processing such as edge grinding, surface polishing, and polishing.

The slicing operation is an operation of preparing a sliced crystal by slicing a silicon carbide ingot to have a certain off-angle. The off-angle is based on the (0001) plane in 4H SiC. The off-angle may be an angle selected from specifically 0 to 15 degrees, 0 to 12 degrees, or 0 to 8 degrees.

The slicing operation may include various methods that are generally used in wafer manufacturing process. For example, the slicing operation may include cutting methods using a diamond wire or a wire to which diamond slurry is applied, using a blade or wheel to which diamond is partially applied, etc. However, the slicing operation may not be limited to the above cutting methods.

The thickness of the sliced crystal may be adjusted in consideration of the thickness of the wafer to be manufactured, and the sliced crystal may be sliced to an appropriate thickness in consideration of the thickness after polishing in a polishing operation described below.

In addition, the slicing starts at a place about 3° away from the point where the outer circumferential surface of the silicon carbide ingot and the second direction meet, and proceeds in the second direction. That is, the direction in which the slicing proceeds may be a direction deviated by about 3° from the second direction. That is, the movement direction of the sawing wire for the slicing may be a direction perpendicular to the second direction and a direction inclined by about 3°. That is, the extension direction of the sawing wire is a direction perpendicular to the second direction and a direction inclined by about 3°, and the silicon carbide ingot is gradually cut in a direction inclined by about 3° from the second direction and may be cut.

Accordingly, in the slicing process, the occurrence of stress in the first direction may be minimized. That is, in the slicing process, since no pressure is applied in the first direction in the slicing process, the stress in the first direction is minimized, and the deviation of the peak omega angle in the first direction may be minimized.

The polishing operation is an operation of forming a silicon carbide wafer by polishing the sliced crystal to a thickness of 300 to 800 um.

For the polishing operation, a polishing method normally applied to wafer manufacturing may be applied, and exemplarily, a method in which lapping and/or grinding, etc. are performed, followed by polishing, etc. may be applied.

The silicon carbide wafer according to one embodiment may have a low surface oxygen concentration. In the silicon carbide wafer according to this embodiment, a surface oxygen concentration measured by the X-ray photoelectron spectroscopy may range from about 5 atom% to about 14 atom%. In the silicon carbide wafer according to one embodiment, a surface oxygen concentration measured by the X-ray photoelectron spectroscopy may range from about 6 atom% to about 13 atom%. In the silicon carbide wafer according to one embodiment, a surface oxygen concentration measured by the X-ray photoelectron spectroscopy may range from about 7 atom% to about 12.5 atom%. In the silicon carbide wafer according to one embodiment, a surface oxygen concentration measured by the X-ray photoelectron spectroscopy may range from about 8 atom% to about 12 atom%.

Accordingly, since the silicon carbide wafer according to one embodiment has a low surface oxygen content, a high yield may be realized when used in the process of manufacturing a power semiconductor device. The silicon carbide wafer according to one embodiment may have a yield of about 88% or more for a power semiconductor device to be fabricated. That is, a method of fabricating a power semiconductor device using the silicon carbide wafer according to one embodiment may provide a yield of about 88% or more.

The silicon carbide powder according to ome embodiment may have the particle characteristics described above. The silicon carbide powder according to onee embodiment may have a flow index, an unconfined failure strength, a repose angle, a tap density and the like within appropriate ranges.

For example, the silicon carbide powder according to one embodiment has a flow index within an appropriate range under the major principal consolidation stress of 9 kPa. In addition, the silicon carbide powder according to one embodiment has a flow index within an appropriate range under a major principal consolidation stress of 0.3 kPa. In addition, the silicon carbide powder according to one embodiment may have the repose angle within an appropriate range. In addition, the silicon carbide powder according to one embodiment may have a tap density within an appropriate range.

In addition, the silicon carbide powder according to one embodiment may have an unconfined failure strength per average particle diameter within an appropriate range under a major principal consolidation stress of 0.3 kPa and 9 kPa. The silicon carbide powder according to one embodiment may have a flow index per average particle diameter within an appropriate range under a major principal consolidation stress of 0.3 kPa and 9 kPa.

Accordingly, the silicon carbide powder of the present disclosure may be filled in a crucible to manufacture a silicon carbide ingot and a silicon carbide wafer. In addition, since the silicon carbide powder of the present disclosure has a flow index, repose angle and tap density in appropriate ranges as described above, it may have an appropriate bulk density when filled in the crucible. In addition, since the silicon carbide powder of the present disclosure has a flow index, repose angle and tap density in appropriate ranges as described above, it may have an appropriate particle shape and appropriate surface characteristics when filled in the crucible, thereby realizing an appropriate porosity and an appropriate thermal conductivity.

Accordingly, when the silicon carbide powder of the present disclosure is filled in the crucible, improved thermal conductivity in a horizontal direction and a porosity in an appropriate range may be provided. Accordingly, when the silicon carbide powder of the present disclosure is filled in the crucible and heated for the growth of the silicon carbide ingot, a uniform temperature gradient in the horizontal direction may be provided, and the silicon carbide gas sublimated into the pores may be transferred to the silicon carbide seed tablet.

Accordingly, the silicon carbide powder of the present disclosure can transfer the sublimated silicon carbide gas upward at an improved rate and at a uniform rate. Therefore, the silicon carbide powder of the present disclosure can improve the growth rate of the silicon carbide ingot. In addition, since the silicon carbide gas is sublimed at a uniform rate as a whole, defects of the silicon carbide ingot and the silicon carbide wafer may be reduced.

The growth process of the silicon carbide ingot may depend upon the shape and surface characteristics of the silicon carbide powder according to one embodiment. At this time, the particle shape and particle surface properties of the silicon carbide powder may be appropriately controlled by the crushing process, the pulverizing process, and the etching process. Through the analysis of the flow index, the repose angle and the tap density, the particle shape and particle surface characteristics of the silicon carbide powder according to one embodiment may be determined. When the silicon carbide powder of the present disclosure has a flow index, repose angle and tap density in appropriate ranges, it can have a particle shape and surface that positively affect the growth of the silicon carbide ingot.

Hereinafter, the embodiment will be specifically described through specific examples. The following examples are merely examples to aid understanding of the embodiment, and the scope of the present disclosure is not limited thereto.

Manufacturing Example 1

A monocrystalline silicon carbide lump was provided as a silicon carbide raw material. The monocrystalline silicon carbide lump may be formed by sublimating a silicon carbide powder with a purity of about 99.9999% or more at about 2300 °C and depositing it on a seed tablet.

The monocrystalline silicon carbide lump was first crushed by a jaw crusher (Henan Dewo Industrial Limited Company, KER-100 × 60). A primary powder having an average particle diameter (D50) of about 6 mm was obtained from the crushed silicon carbide lump.

Next, the primary powder was secondarily pulverized by a ball mill (Ganzhou Li Ang Machinery Co., Ltd., QM400 * 600). Here, a steel ball with a diameter of about 25.4 mm was placed in a cylinder, and the diameter of the cylinder was about 400 mm. In addition, the rotation speed of the cylinder was about 20 rpm, and the secondary pulverization process was carried out for about 15 minutes. The secondarily pulverized primary powder was classified with a classifier, and a secondary powder having an average particle diameter (D50) of about 500 μm was obtained.

Next, the secondary powder was heat treated for about 24 hours at about 1200 °C in an air atmosphere, thereby removing free carbon and free silicon.

Next, the thermally treated silicon carbide powder was purified by a wet-etching process.

An etchant was prepared by mixing deionized water, hydrofluoric acid and nitric acid in a volume ratio of about 2:1:1.

Next, about 1 L of the thermally treated silicon carbide powder was put into an etching container having a volume of about 5 L, and about 0.8 L of the etchant was added.

Next, the etching container was sealed with a lid. Here, an oil vapor generated in the etching container was discharged through the lid, and the oil vapor was recovered by the scrubber.

The etchant and the thermally treated silicon carbide powder were stirred for about 1 hour at a speed of about 26 rpm.

Next, the etchant was drained, and the wet-etched silicon carbide powder was neutralized by deionized water in the following process. The wet-etched silicon carbide powder was immersed in deionized water and, after stirring, the deionized water was discharged. The immersion and discharge processes were repeated until the pH of the discharged deionized water reached 7.

Next, the neutralized silicon carbide powder was dried at about 80 °C for about 30 minutes.

Next, the dried silicon carbide powder was placed in a graphite crucible.

Next, an inner temperature of the crucible was elevated up to about 2000 °C, and the pressure inside the crucible was reduced to about 8 Torr.

Next, an etching gas in which an argon gas and a chlorine gas were mixed in a volume ratio of about 10 : 1 was added into the crucible, and the pressure inside the crucible was elevated to about 760 Torr. Here, the temperature of the crucible was set so that the temperature of a lower part of the crucible was about 50 °C higher than the temperature of an upper part of the crucible. This condition was maintained for about 2 days.

Next, an etching gas inside the crucible was recovered with a scrubber, and the inside of the crucible where the dry-etched silicon carbide powder was disposed was thermally treated at about 1000 °C in an air atmosphere for about 10 hours.

Next, the thermally treated silicon carbide powder was immersed in an aqueous hydrofluoric acid solution at a concentration of about 0.5 wt%, and the silicon carbide powder and the aqueous hydrofluoric acid solution were stirred for about 1 hour.

Next, the silicon carbide powder treated with the aqueous hydrofluoric acid solution was immersed in ultrapure water and washed by repeating the process in which the ultrapure water was drained. Here, the immersion process and the draining process were repeated until the concentration of hydrofluoric acid included in the drained ultrapure water was lowered to about 0.0001 wt% or less.

Manufacturing Examples 2 to 6

A primary crushing process and a secondary pulverization process were substantially the same as those of Manufacturing Example 1 and performed as in Table 1 below.

Table 1

| Classification | Average particle diameter (D50, mm) of primary powder an | Ball diameter (mm) | Number of cylinder revolutions (rpm) | Time (min) of second pulverization | Average particle diameter (D50, μm) of secondary powder |
| --- | --- | --- | --- | --- | --- |
| Manufacturing Example 1 | 6 | 25.4 | 22 | 30 | 150 |
| Manufacturing Example 2 | 6 | 25.4 | 21 | 14 | 500 |
| Manufacturing Example 3 | 6 | 25.4 | 22 | 10 | 1000 |
| Manufacturing Example 4 | 10 | 37 | 21 | 10 | 2000 |

(continued)

| Classification | Average particle diameter (D50, mm) of primary powder an | Ball diameter (mm) | Number of cylinder revolutions (rpm) | Time (min) of second pulverization | Average particle diameter (D50, $\mu$m) of secondary powder |
|---|---|---|---|---|---|
| Manufacturing Example 5 | 10 | 25.4 | 23 | 11 | 3000 |
| Manufacturing Example 6 | 8 | 37 | 24 | 18 | 450 |

As shown in Tables 2 to 4 below, the 2D image analysis, flow index, unconfined failure strength, tap density of the silicon carbide powder, etc. of each of Manufacturing Examples 1 to 6 were examined.

Table 2

| Classification | Repose angle (°) | UFS at 0.3 kPa (kPa) | UFS at 9 kPa (kPa) | FI at 0.3 kPa | FI at 9 kPa | Tap density (kg/m$^3$) |
|---|---|---|---|---|---|---|
| Manufacturing Example 1 | 29.5 | 0.03 | 0.79 | 0.1 | 0.088 | 1550 |
| Manufacturing Example 2 | 33.4 | 0.03 | 0.35 | 0.1 | 0.039 | 1705 |
| Manufacturing Example 3 | 35.3 | 0.02 | 0.45 | 0.067 | 0.050 | 1629 |
| Manufacturing Example 4 | 36.5 | 0.02 | 0.37 | 0.067 | 0.041 | 1610 |
| Manufacturing Example 5 | 35.1 | 0.01 | 0.43 | 0.033 | 0.048 | 1740 |
| Manufacturing Example 6 | 34.5 | 0.02 | 0.32 | 0.067 | 0.036 | 1650 |
| UFS: Unconfined failure strength FI: Flow index | | | | | | |

Table 3

| Classification | UFS at 0.3 kPa / D50 ( Pa/$\mu$m) | UFS at 9 kPa / D50 ( Pa/$\mu$m) | FI at 0.3 k Pa/ FI at 9 kPa |
|---|---|---|---|
| Manufacturing Example 1 | 0.200 | 5.267 | 1.14 |
| Manufacturing Example 2 | 0.060 | 0.700 | 2.56 |
| Manufacturing Example 3 | 0.020 | 0.450 | 1.34 |
| Manufacturing Example 4 | 0.010 | 0.185 | 1.63 |
| Manufacturing Example 5 | 0.003 | 0.143 | 0.688 |
| Manufacturing Example 6 | 0.044 | 0.711 | 1.861 |
| D50: Average particle diameter | | | |

Table 4

| Classification | Particle circularity | Particle elongation | Particle convexity |
|---|---|---|---|
| Manufacturing Example 1 | 0.671 | 0.86 | 0.940 |
| Manufacturing Example 2 | 0.620 | 0.82 | 0.94 |
| Manufacturing Example 3 | 0.613 | 0.89 | 0.89 |
| Manufacturing Example 4 | 0.620 | 0.87 | 0.87 |
| Manufacturing Example 5 | 0.627 | 0.91 | 0.89 |
| Manufacturing Example 6 | 0.642 | 0.88 | 0.94 |

Examples

Next, the silicon carbide powder manufactured in Manufacturing Example 1 was loaded into a graphite crucible body. A silicon carbide seed tablet and a seed tablet holder were placed on the top of the powder. Here, the C surface (0001) of the silicon carbide seed tablet (4H SiC single crystal, 6 inches) was fixed in a general method to face the bottom of the crucible. In addition, a crucible cover and a seed tablet holder were integrally formed with graphite, and both the crucible cover and the seed tablet holder had a disc shape. Here, the thickness of the crucible cover was about 20 mm, the diameter of the crucible cover was about 210 mm, the thickness of the seed tablet holder was about 3 mm, and the diameter of the seed tablet holder was about 180 mm.

The crucible main body was covered with a crucible cover in which the seed tablet and the seed tablet holder were installed, surrounded by an insulator, and placed in a reaction chamber equipped with a heating coil as a heating device.

Here, a graphite felt having a density of about 0.19 g/cc, a porosity of about 85 vol%, and a compressive strength of about 0.37 MPa was applied as an insulator.

After evacuating the inside of the crucible, argon gas was slowly injected thereinto so that the inside of the crucible reached atmospheric pressure, and then the inside of the crucible was gradually decompressed. At the same time, the temperature inside the crucible was gradually elevated up to 2000 °C at a heating rate of about 3 °C/min and gradually elevated to 2350 °C at a heating rate of about 5 °C/min.

Next, a SiC ingot was grown from a silicon carbide seed tablet for 100 hours under conditions of 2350°C and a pressure of 20 Torr.

Next, the silicon carbide ingot was cut by a diamond wire saw and processed by chamfering, grinding and polishing processes. Accordingly, a silicon carbide wafer with an angle-off of 4 degrees with respect to the (0001) plane was manufactured.

Examples 2 to 6 and Comparative Example

As shown in Table 5 below, experiments were carried out in the same manner as in Example 1 except that the silicon carbide powder was changed.

Table 5

| Classification | Silicon carbide powder | Bulk density (kg/ $m^3$) | Porosity (vol%) |
|---|---|---|---|
| Example 1 | Manufacturing Example 1 | 1440 | 48.2 |
| Example 2 | Manufacturing Example 2 | 1689 | 47.5 |
| Example 3 | Manufacturing Example 3 | 1518 | 48.8 |
| Example 4 | Manufacturing Example 4 | 1493 | 48.1 |
| Example 5 | Manufacturing Example 5 | 1625 | 47.8 |
| Example 6 | Manufacturing Example 6 | 1544 | 48.5 |
| Comparative example | Carborex manufactured by Washington Mills | 1525 | 48.3 |

Since the silicon carbide powders manufactured according to the examples have a flow index, tap density, particle circularity, particle ellipticity and particle convexity in appropriate ranges as shown in Table 6 below, a silicon carbide ingot having a higher growth rate and fewer defects may be manufactured.

Table 6

| Classification | Growth rate ($\mu$m/hr) | Defect (EPD, / cm$^2$) |
|---|---|---|
| Example 1 | 281 | 9913 |
| Example 3 | 283 | 7812 |
| Example 4 | 270 | 9612 |
| Example 5 | 269 | 14330 |
| Example 6 | 276 | 14910 |
| Example 7 | 272 | 13761 |
| Comparative example | 250 | 16351 |

Measurement examples

1. Purity of silicon carbide powder

The purity of the silicon carbide powder according to the manufacturing example was measured by glow discharge mass spectrometry.

2. Shape of silicon carbide powder

About 1 g of the silicon carbide powder manufactured in the manufacturing example was sampled about 30 times. The samples were taken by an optical microscope (Eclipse LV150 Microscope, manufactured by Nikon) and analyzed by an image analysis program (i-solution, manufactured by IMT). The area, perimeter, equivalent circle diameter, maximum ellipse diameter, minimum ellipse diameter, maximum length, maximum frame diameter, minimum frame diameter, middle frame diameter and convex hull of each particle were measured. Respective values measured from each particle were derived as an average value.

3. Repose angle

When a powder was poured onto a horizontal surface, the angle of inclination between an inclined plane of a cone reaching a horizontal plane and the horizontal plane was measured. The angle was calculated by measuring a height by means of a height-measuring gauge on a circular support with a 100 mm diameter.

4. UPS

After agglomerating the powder by applying a certain pressure (consolidation stress, CS) in a confined space, the confined space was leased, and then a pressure (unconfined failure strength, UFS) where the agglomeration collapsed was measured to derive the slope of the trend line obtained when plotting an X-axis with CS and a Y-axis with UFS. UFS was measured using Powder Flow Tester manufactured by Brookfield.

5. Tap density

The tap density was measured using a Tapped Density Tester. 100 g of a powder sample was put into a graduated 250 ml cylinder, the number of taps was increased, and an apparent density was measured at the point where a volume change amount changed within 2%.

6. Bulk density

The bulk density was measured using Powder Flow Tester manufactured by Brookfield.
A density was calculated by putting 100 g of a powder sample in a graduated 250 ml cylinder and measuring the volume thereof.

Description of Symbols

crucible body 20
insulator 40
silicon carbide ingot 12

**Claims**

1. A silicon carbide powder, comprising:

   carbon; and
   silicon,
   wherein a flow index of the silicon carbide powder under a major principal consolidation stress of 9 kPa ranges from 0.005 to 0.3, and a flow index of the silicon carbide powder under a major principal consolidation stress of 0.3 kPa ranges from 0.01 to 0.5.

2. The silicon carbide powder according to claim 1, wherein the flow index of the silicon carbide powder under a major principal consolidation stress of 9 kPa ranges from 0.01 to 0.1, and the flow index of the silicon carbide powder under a major principal consolidation stress of 0.3 kPa ranges from 0.02 to 0.3.

3. The silicon carbide powder according to claim 1, wherein an average particle diameter of the silicon carbide powder ranges from 100 $\mu$m to 5000 $\mu$m.

4. The silicon carbide powder according to claim 1, wherein a ratio of the flow index under a major principal consolidation stress of 0.3 kP to the flow index under a major principal consolidation stress of 9 kPa ranges from 1:1 to 4:1.

5. The silicon carbide powder according to claim 1, wherein a repose angle of the silicon carbide powder ranges from 30° to 45°.

6. The silicon carbide powder according to claim 1, wherein a tap density of the silicon carbide powder ranges from 1000 kg/m$^3$ to 2000 kg/m$^3$.

7. The silicon carbide powder according to claim 1, wherein an unconfined failure strength of the silicon carbide powder under a major principal consolidation stress of 9 kPa ranges from 0.2 kPa to 1 kPa.

8. The silicon carbide powder according to claim 1, wherein the flow index under a major principal consolidation stress of 9 kPa relative to an average particle diameter is less than 0.0006/$\mu$m.

9. The silicon carbide powder according to claim 1, wherein the flow index under a major principal consolidation stress of 0.3 kPa relative to an average particle diameter is less than 0.0007/$\mu$m.

FIG. 1

| CRUSH SILICON CARBIDE RAW MATERIAL | S10 |

↓

| REMOVE CARBON-BASED MATERIAL | S20 |

↓

| PULVERIZE SILICON CARBIDE RAW MATERIAL | S30 |

↓

| WET-ETCH SILICON CARBIDE RAW MATERIAL | S40 |

↓

| DRY-ETCH SILICON CARBIDE RAW MATERIAL | S50 |

↓

| CLEAN SILICON CARBIDE RAW MATERIAL | S60 |

↓

| CLASSIFY SILICON CARBIDE RAW MATERIAL | S70 |

FIG. 2

```
┌─────────────────────────────────────────────┐
│        REMOVE CARBON-BASED MATERIAL           │──── S1
└─────────────────────────────────────────────┘
                      │
                      ▼
┌─────────────────────────────────────────────┐
│       CRUSH SILICON CARBIDE RAW MATERIAL      │──── S10
└─────────────────────────────────────────────┘
                      │
                      ▼
┌─────────────────────────────────────────────┐
│     PULVERIZE SILICON CARBIDE RAW MATERIAL    │──── S30
└─────────────────────────────────────────────┘
                      │
                      ▼
┌─────────────────────────────────────────────┐
│     WET-ETCH SILICON CARBIDE RAW MATERIAL     │──── S40
└─────────────────────────────────────────────┘
                      │
                      ▼
┌─────────────────────────────────────────────┐
│     DRY-ETCH SILICON CARBIDE RAW MATERIAL     │──── S50
└─────────────────────────────────────────────┘
                      │
                      ▼
┌─────────────────────────────────────────────┐
│       CLEAN SILICON CARBIDE RAW MATERIAL      │──── S60
└─────────────────────────────────────────────┘
                      │
                      ▼
┌─────────────────────────────────────────────┐
│     CLASSIFY SILICON CARBIDE RAW MATERIAL     │──── S70
└─────────────────────────────────────────────┘
```

FIG. 3

| CRUSH SILICON CARBIDE RAW MATERIAL | — S10 |

| PULVERIZE SILICON CARBIDE RAW MATERIAL | — S30 |

| WET-ETCH SILICON CARBIDE RAW MATERIAL | — S40 |

| DRY-ETCH SILICON CARBIDE RAW MATERIAL | — S50 |

| CLEAN SILICON CARBIDE RAW MATERIAL | — S60 |

| CLASSIFY SILICON CARBIDE RAW MATERIAL | — S70 |

FIG. 4

```
┌─────────────────────────────────────────────┐
│      CRUSH SILICON CARBIDE RAW MATERIAL       │── S10
└─────────────────────────────────────────────┘
                       │
                       ▼
┌─────────────────────────────────────────────┐
│        REMOVE CARBON-BASED MATERIAL           │── S20
└─────────────────────────────────────────────┘
                       │
                       ▼
┌─────────────────────────────────────────────┐
│    PULVERIZE SILICON CARBIDE RAW MATERIAL     │── S30
└─────────────────────────────────────────────┘
                       │
                       ▼
┌─────────────────────────────────────────────┐
│     CLASSIFY SILICON CARBIDE RAW MATERIAL     │── S31
└─────────────────────────────────────────────┘
                       │
                       ▼
┌─────────────────────────────────────────────┐
│    WET-ETCH SILICON CARBIDE RAW MATERIAL      │── S40
└─────────────────────────────────────────────┘
                       │
                       ▼
┌─────────────────────────────────────────────┐
│    DRY-ETCH SILICON CARBIDE RAW MATERIAL      │── S50
└─────────────────────────────────────────────┘
                       │
                       ▼
┌─────────────────────────────────────────────┐
│      CLEAN SILICON CARBIDE RAW MATERIAL       │── S60
└─────────────────────────────────────────────┘
```

FIG. 5

```
┌─────────────────────────────────────────────┐
│        REMOVE CARBON-BASED MATERIAL           │ ⟍ S1
└─────────────────────────────────────────────┘
                      │
                      ▼
┌─────────────────────────────────────────────┐
│        CRUSH SILICON CARBIDE RAW MATERIAL     │ ⟍ S10
└─────────────────────────────────────────────┘
                      │
                      ▼
┌─────────────────────────────────────────────┐
│      PULVERIZE SILICON CARBIDE RAW MATERIAL   │ ⟍ S30
└─────────────────────────────────────────────┘
                      │
                      ▼
┌─────────────────────────────────────────────┐
│      CLASSIFY SILICON CARBIDE RAW MATERIAL    │ ⟍ S31
└─────────────────────────────────────────────┘
                      │
                      ▼
┌─────────────────────────────────────────────┐
│     WET-ETCH SILICON CARBIDE RAW MATERIAL     │ ⟍ S40
└─────────────────────────────────────────────┘
                      │
                      ▼
┌─────────────────────────────────────────────┐
│     DRY-ETCH SILICON CARBIDE RAW MATERIAL     │ ⟍ S50
└─────────────────────────────────────────────┘
                      │
                      ▼
┌─────────────────────────────────────────────┐
│       CLEAN SILICON CARBIDE RAW MATERIAL      │ ⟍ S60
└─────────────────────────────────────────────┘
```

FIG. 6

```
┌──────────────────────────────────────────────────────┐
│        CRUSH SILICON CARBIDE RAW MATERIAL              │ ⟋ S10
└──────────────────────────────────────────────────────┘
                          │
                          ▼
┌──────────────────────────────────────────────────────┐
│      PULVERIZE SILICON CARBIDE RAW MATERIAL            │ ⟋ S30
└──────────────────────────────────────────────────────┘
                          │
                          ▼
┌──────────────────────────────────────────────────────┐
│       CLASSIFY SILICON CARBIDE RAW MATERIAL            │ ⟋ S31
└──────────────────────────────────────────────────────┘
                          │
                          ▼
┌──────────────────────────────────────────────────────┐
│       WET-ETCH SILICON CARBIDE RAW MATERIAL            │ ⟋ S40
└──────────────────────────────────────────────────────┘
                          │
                          ▼
┌──────────────────────────────────────────────────────┐
│       DRY-ETCH SILICON CARBIDE RAW MATERIAL            │ ⟋ S50
└──────────────────────────────────────────────────────┘
                          │
                          ▼
┌──────────────────────────────────────────────────────┐
│        CLEAN SILICON CARBIDE RAW MATERIAL             │ ⟋ S60
└──────────────────────────────────────────────────────┘
```

FIG. 7

Europäisches
Patentamt

European
Patent Office

Office européen
des brevets

# EUROPEAN SEARCH REPORT

Application Number

EP 23 19 3344

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 763 852 A1 (SKC CO LTD [KR]) 13 January 2021 (2021-01-13) | 1-7 | INV. C01B32/956 |
| A | * paragraphs [0050] – [0063]; claims 1-8; figure 3; examples 1-6; tables 1-3 * | 8,9 | C01B32/963 C01B32/984 |
| A | EP 3 712 303 A1 (SKC CO LTD [KR]) 23 September 2020 (2020-09-23) * claims 1-5; table 1 * | 1-9 | |
| A | US 2021/123843 A1 (PARK JONG HWI [KR] ET AL) 29 April 2021 (2021-04-29) * paragraphs [0041] – [0163] * | 1-9 | |

TECHNICAL FIELDS
SEARCHED        (IPC)

C01B

The present search report has been drawn up for all claims

| Place of search | Date of completion of the search | Examiner |
|---|---|---|
| The Hague | 9 February 2024 | Corrias, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 3344

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2024

| Patent document cited in search report | | | Publication date | Patent family member(s) | | | Publication date |
|---|---|---|---|---|---|---|---|
| EP | 3763852 | A1 | 13-01-2021 | CN | 112210824 | A | 12-01-2021 |
| | | | | EP | 3763852 | A1 | 13-01-2021 |
| | | | | JP | 6758527 | B1 | 23-09-2020 |
| | | | | JP | 2021014395 | A | 12-02-2021 |
| | | | | KR | 102068933 | B1 | 21-01-2020 |
| | | | | TW | 202102730 | A | 16-01-2021 |
| | | | | US | 10822720 | B1 | 03-11-2020 |
| EP | 3712303 | A1 | 23-09-2020 | CN | 111719181 | A | 29-09-2020 |
| | | | | EP | 3712303 | A1 | 23-09-2020 |
| | | | | JP | 6895496 | B2 | 30-06-2021 |
| | | | | JP | 2020152632 | A | 24-09-2020 |
| | | | | KR | 20200112330 | A | 05-10-2020 |
| | | | | TW | 202035805 | A | 01-10-2020 |
| | | | | US | 2020299859 | A1 | 24-09-2020 |
| US | 2021123843 | A1 | 29-04-2021 | CN | 112746317 | A | 04-05-2021 |
| | | | | EP | 3816329 | A1 | 05-05-2021 |
| | | | | JP | 2021070623 | A | 06-05-2021 |
| | | | | KR | 20210050858 | A | 10-05-2021 |
| | | | | TW | 202117103 | A | 01-05-2021 |
| | | | | US | 2021123843 | A1 | 29-04-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002326876 A